# EUROPEAN PATENT APPLICATION

(11) **EP 4 686 334 A1**
(43) Date of publication of application: **28.01.2026**
(21) Application number: 23930154.2
(22) Date of filing: 29.12.2023
(51) Int. Cl.: H10B 12/00, H01L 27/00

(54) **THREE-DIMENSIONAL MEMORY ARRAY AND PREPARATION METHOD THEREFOR, MEMORY, AND ELECTRONIC DEVICE**

(30) Priority: 31.03.2023 CN 202310373611
(71) Applicant: Huawei Technologies Co., Ltd., Shenzhen, Guangdong 518129 (CN)
(72) Inventor: JING, Weiliang, Shenzhen, Guangdong 518129 (CN); HUANG, Kailiang, Shenzhen, Guangdong 518129 (CN); SUN, Ying, Shenzhen, Guangdong 518129 (CN); WANG, Zhengbo, Shenzhen, Guangdong 518129 (CN); LIAO, Heng, Shenzhen, Guangdong 518129 (CN)
(74) Representative: Isarpatent
(86) International application number: PCT/CN2023/143201
(87) International publication number: WO 2024/198592

(57) **Abstract**

Embodiments of this application provide a three-dimensional memory array, a preparation method thereof, a memory, and an electronic device, and relate to the field of storage technologies, to improve storage density of the three-dimensional memory array. The three-dimensional memory array includes a substrate, a stacked structure and a plurality of penetrating pillars. The stacked structure is disposed on the substrate, and the stacked structure includes a plurality of memory layers that are stacked in a first direction perpendicular to the substrate; the memory layer includes a plurality of word lines and a plurality of memory cells; and the memory cells are electrically connected to the word lines at a same memory layer. The penetrating pillar penetrates the stacked structure in the first direction, and the penetrating pillar includes a bit line extending in the first direction. At each memory layer, two memory cells correspond to one penetrating pillar, and the two memory cells corresponding to the penetrating pillar are disposed opposite to each other on two sides of the penetrating pillar in a second direction and are electrically connected to a bit line in the penetrating pillar; and the first direction is perpendicular to the second direction. The three-dimensional memory array may be applied to a memory and an electronic device.

## Description

This application claims priority to Chinese Patent Application No. 202310373611.X, filed with the China National Intellectual Property Administration on March 31, 2023 and entitled "THREE-DIMENSIONAL MEMORY ARRAY AND PREPARATION METHOD THEREOF, MEMORY, AND ELECTRONIC DEVICE", which is incorporated herein by reference in its entirety.

### TECHNICAL FIELD

This application relates to the field of storage technologies, and in particular, to a three-dimensional memory array and a preparation method thereof, a memory, and an electronic device.

### BACKGROUND

A dynamic random access memory (Dynamic Random Access Memory, DRAM) is a common semiconductor memory. A memory cell of the dynamic random access memory adopts a 1T1C architecture, and includes a transistor and a capacitor.

With development of semiconductor technologies, a feature size of a memory cell is continuously reduced. However, as a size of a memory cell decreases, a series of problems are generated, for example, a short channel effect of a transistor in the memory cell, which causes a limitation on storage density increase of a planar (2D) DRAM.

In view of this, a related technology provides a 3D DRAM based on a 1T1C storage architecture, and storage density of the DRAM is increased in a vertical stacking manner. However, with progress of semiconductor technologies, the 3D DRAM based on the 1T1C storage architecture also encounters a bottleneck in improving the storage density.

### SUMMARY

Embodiments of this application provide a three-dimensional memory array and a preparation method thereof, a memory, and an electronic device, to improve storage density of the three-dimensional memory array.

To achieve the foregoing objectives, the following technical solutions are used in this application.

According to a first aspect, an embodiment of this application provides a three-dimensional memory array, where the three-dimensional memory array includes a substrate, a stacked structure, and a plurality of penetrating pillars. The stacked structure is disposed on the substrate, and the stacked structure includes a plurality of memory layers that are stacked in a first direction perpendicular to the substrate; the memory layer includes a plurality of word lines and a plurality of memory cells; and the memory cells are electrically connected to the word lines at a same memory layer.

The penetrating pillar penetrates the stacked structure in the first direction, and the penetrating pillar includes a bit line extending in the first direction.

At each memory layer, two memory cells correspond to one penetrating pillar, and the two memory cells corresponding to the penetrating pillar are disposed opposite to each other on two sides of the penetrating pillar in a second direction and are electrically connected to a bit line in the penetrating pillar; and the first direction is perpendicular to the second direction.

In the three-dimensional memory array provided in this embodiment of this application, two memory cells corresponding to one penetrating pillar are disposed at each memory layer. In comparison with a solution in which one memory cell corresponding to one penetrating pillar is disposed at each memory layer in a related technology, in the three-dimensional memory array in this embodiment of this application, more memory cells can be disposed at the memory layer in a same layout of the penetrating pillar, so that storage density and a storage capacity of the three-dimensional memory array are improved.

In addition, the two memory cells corresponding to the penetrating pillar are disposed opposite to each other on the two sides of the penetrating pillar in the second direction, so that space of an outer circumferential region of the penetrating pillar can be appropriately used. Each memory cell can be disposed at a location that is close to the corresponding penetrating pillar, so that a total area occupied by the two memory cells corresponding to the penetrating pillar at the memory layer can be reduced, more penetrating pillars and memory cells can be disposed in a same area, and storage density and a storage capacity of the three-dimensional memory array are improved.

In some embodiments, at the memory layer, the two memory cells corresponding to the penetrating pillar at the memory layer are of a symmetric structure relative to the penetrating pillar. Memory cells of a symmetric structure are used, so that preparation of the memory cell is facilitated, a preparation process of the memory cell is simplified, and preparation efficiency is improved. In addition, space of the outer circumferential region of the penetrating pillar can be appropriately used, a total area occupied by the two memory cells corresponding to the penetrating pillar at the memory layer is reduced, more penetrating pillars and memory cells can be disposed in a same area, and storage density and a storage capacity of the three-dimensional memory array are improved.

In some embodiments, the memory cell includes a transistor and a capacitor electrically connected to the transistor, where the transistor includes a channel layer, a gate dielectric layer, a gate, a first electrode, and a second electrode.

The channel layer is disposed on one side of the penetrating pillar, and the gate dielectric layer is disposed on at least one side of the channel layer in the first direction. The gate connected to the word line at the memory layer is disposed on a side that is of the gate dielectric layer and that is away from the channel layer in the first direction. The first electrode and the second electrode are disposed on two sides of the channel layer in the second direction.

The second direction is perpendicular to the first direction, and the first electrode and the bit line in the penetrating pillar are of an integrated structure or of independent structures that are electrically connected to each other; and the second electrode is far away from the penetrating pillar relative to the channel layer and is connected to the capacitor.

In the memory cell having the foregoing structure, the first electrode and the second electrode in the transistor are disposed on the two sides of the channel layer in the second direction, the first electrode is connected to the bit line, and the second electrode is connected to the capacitor. Therefore, it can be seen that an overall extension direction of the transistor is parallel to the second direction, and the capacitor and the transistor are arranged in the second direction. Therefore, a size of the memory cell in the first direction can be reduced, a thickness of a single memory layer can be reduced, and storage density of the three-dimensional memory array is improved.

In addition, in some implementations, the first electrode of the transistor and the bit line in the penetrating pillar may be of an integrated structure. By using a structure sharing design, a size of the memory cell can be further reduced, and storage density of the three-dimensional memory array can be further improved.

In some embodiments, the first electrode and the bit line are of an integrated structure, and the channel layer, the gate dielectric layer, and the second electrode are of semi-annular structures extending around the penetrating pillar in the outer circumferential region of the penetrating pillar; or the first electrode and the bit line are of independent structures that are electrically connected to each other, and the first electrode, the channel layer, the gate dielectric layer, and the second electrode are of semi-annular structures extending around the penetrating pillar in the outer circumferential region of the penetrating pillar.

In the memory cell provided in this embodiment of this application, at least some structures in the transistor are of semi-annular structures extending around the penetrating pillar. In this design, a size of the transistor can be reduced while normal working performance of the transistor is ensured, so that a size of the memory cell is reduced, and storage density of the three-dimensional memory array is improved.

In some embodiments, the second electrode includes a first part, a second part, and a third part, where the first part extends in the first direction and is in contact with an outer circumferential surface of the channel layer; the second part and the third part are disposed opposite to each other at two ends of the first part in the first direction and extend towards the channel layer in the second direction; and the second part and the third part are respectively in contact with opposite surfaces of the channel layer in the first direction.

The transistor in the memory cell has the second electrode having the foregoing structure, so that a contact area between the second electrode and the channel layer can be increased, and performance of the transistor in the memory cell is improved.

In some embodiments, the three-dimensional memory array further includes a plate line.

In the three-dimensional memory array, the memory cell includes the transistor and the capacitor arranged in the second direction, where the second direction is perpendicular to the first direction, and the capacitor is away from the penetrating pillar relative to the transistor.

The transistor includes the gate, the first electrode, and the second electrode, the gate is connected to the word line, the first electrode is connected to the bit line, and the second electrode is connected to the capacitor.

The capacitor includes a first capacitor plate, a capacitor dielectric layer, and a second capacitor plate that are arranged in the second direction, and the first capacitor plate and the second electrode in the transistor are of an integrated structure or of independent structures that are electrically connected to each other; and the second capacitor plate and the plate line are of an integrated structure or of independent structures that are electrically connected to each other.

In the memory cell having the foregoing structure, the transistor and the capacitor are arranged in the second direction, and the first capacitor plate, the capacitor dielectric layer, and the second capacitor plate in the capacitor are also arranged in the second direction. In this way, a size of the memory cell in the first direction can be reduced, a thickness of a single memory layer can be reduced, and storage density of the three-dimensional memory array is improved.

In addition, in some implementations, the first capacitor plate and the second electrode in the transistor may be of an integrated structure, and the second capacitor plate and the plate line are of an integrated structure. By using a structure sharing design, a size of the memory cell can be further reduced, and storage density of the three-dimensional memory array can be further improved.

In some embodiments, a material of the capacitor dielectric layer includes any one of a ferroelectric material, an insulation material, a phase change material, a resistive material, or a ferromagnetic material. The capacitor dielectric layer uses different materials, so that the three-dimensional memory array provided in this embodiment of this application can form different types of memories, and an application range and an application scenario of the three-dimensional memory array are improved.

In some embodiments, the second capacitor plate and the plate line are of an integrated structure, and the first capacitor plate and the capacitor dielectric layer are of semi-annular structures extending around the penetrating pillar in the outer circumferential region of the penetrating pillar; or
the second capacitor plate and the plate line are of independent structures that are electrically connected to each other, and the first capacitor plate, the capacitor dielectric layer, and the second capacitor plate are of semi-annular structures extending around the penetrating pillar in the outer circumferential region of the penetrating pillar.

In the three-dimensional memory array provided in this embodiment of this application, the capacitor of the memory cell adopts a semi-annular design, so that a large capacitance value in a small size can be implemented, a size of the memory cell is reduced, and performance is improved.

In some embodiments, the second electrode and the first capacitor plate are of an integrated structure or of independent structures that are electrically connected to each other; the first capacitor plate has a fitting groove with an opening facing the second capacitor plate; and the second capacitor plate includes a fitting part extending into the fitting groove, and the capacitor dielectric layer is disposed in a gap between the fitting groove and the fitting part. The first capacitor plate is designed with the fitting groove, so that a contact area between the first capacitor plate and the capacitor dielectric layer can be increased, capacitance of the capacitor can be improved, and performance of the memory cell is improved.

In some embodiments, the first capacitor plate includes a fourth part, a fifth part, and a sixth part, the fourth part extends in the first direction, and the fifth part and the sixth part are disposed at two ends of the fourth part in the first direction and both extend towards the second capacitor plate; and the fourth part, the fifth part, and the sixth part form the fitting groove through limitation. The fitting groove in the first capacitor plate is formed by using the fourth part, the fifth part, and the sixth part, and has a simple structure and is easy to implement.

In some embodiments, the memory cells at the memory layer are arranged in rows and columns, and a column direction is parallel to the second direction.
memory cells located in a same column include two adjacent memory cells whose capacitors are close to each other; and second capacitor plates that are of the two capacitors and that are in the two adjacent memory cells whose capacitors are close to each other are of an integrated structure.

In the three-dimensional memory array provided in this embodiment of this application, a structure sharing design is used for some memory cells at the memory layer, for example, sharing the second capacitor plate. This helps simplify a structure and reduce a size of the memory cell, facilitates disposing more memory cells at the memory layer, and improves storage density of the three-dimensional memory array.

In some embodiments, the penetrating pillar includes two bit lines, and the two memory cells corresponding to the penetrating pillar are connected to the two bit lines in the penetrating pillar in a one-to-one correspondence; or the penetrating pillar includes one bit line, and the two memory cells corresponding to the penetrating pillar are connected to the bit line in the penetrating pillar. The three-dimensional memory array provided in this embodiment of this application can adapt to penetrating pillars having different structures, so that an application scope and an application scenario of the three-dimensional memory array can be improved.

In some embodiments, the three-dimensional memory array includes a word line and a bit line, and connection manners between the two memory cells corresponding to the penetrating pillar and the word line and the bit line include:
the two memory cells are connected to different word lines and different bit lines;
the two memory cells are connected to a same word line and different bit lines; and
the two memory cells are connected to different word lines and a same bit line.

In the three-dimensional memory array provided in this embodiment of this application, the memory cell is connected to the word line and the bit line in a plurality of different manners, so that an application scope and an application scenario of the three-dimensional memory array can be improved.

In some embodiments, the three-dimensional memory array further includes an interconnection structure and a plurality of interconnection contacts, and the interconnection contacts are connected to the word lines in the stacked structure and the interconnection structure; the stacked structure includes an array region and an electrical connection region that are arranged in a third direction; the memory cell is located in the array region, and the word line extends to the electrical connection region and is connected to the interconnection contact in the electrical connection region; and the third direction is perpendicular to the first direction.

Connection manners between the word line, the interconnection contact, and the interconnection structure include:
the interconnection structure is disposed in a top region or a bottom region of the stacked structure, and the memory layers in the stacked structure extend in the third direction and form a step structure in the electrical connection region; and the word line at the memory layer is exposed on a side that is of the step structure and that is close to the interconnection structure, and the interconnection contact extends in the first direction and is connected to the interconnection structure and the word line; and
the interconnection structure is disposed in a top region or a bottom region of the stacked structure, the word line at the memory layer extends in the electrical connection region and is exposed on a surface of a side that is of the electrical connection region and that is close to the interconnection structure, and the interconnection contact extends in the first direction and is connected to the interconnection structure and the word line.

In the three-dimensional memory array provided in this embodiment of this application, there are a plurality of different word line lead-out manners, so that an application scope and an application scenario of the three-dimensional memory array can be improved.

According to a second aspect, an embodiment of this application also provides a three-dimensional memory array preparation method, where the preparation method includes:
manufacturing an initial stacked structure on a substrate, where the initial stacked structure includes a plurality of dielectric combination layers stacked in a first direction perpendicular to the substrate;
manufacturing a first via that penetrates the initial stacked structure in the first direction; and
manufacturing a memory cell and a word line at a dielectric combination layer, and manufacturing a penetrating pillar in the first via.

The penetrating pillar includes a bit line extending in the first direction; and at each dielectric combination layer, the memory cell is connected to the word line at a same dielectric combination layer, two memory cells correspond to one penetrating pillar, and the two memory cells corresponding to the penetrating pillar are disposed opposite to each other on two sides of the penetrating pillar in a second direction and are electrically connected to the bit line in the penetrating pillar.

The first direction is perpendicular to the second direction.

In some embodiments, the dielectric combination layer includes a first dielectric layer, a second dielectric layer, a third dielectric layer, and a fourth dielectric layer that are stacked in the first direction.

Steps of manufacturing the memory cell and the word line at the dielectric combination layer, and manufacturing the penetrating pillar in the first via include:
manufacturing a first annular structure, a second annular structure, and a third annular structure at a location of the third dielectric layer through the first via, where the first annular structure, the second annular structure, and the third annular structure extend around the first via;
manufacturing a through groove at a location of the first via, to form a gate dielectric layer, a second electrode, and a channel layer of a transistor, where the through groove extends in a third direction, and penetrates through the initial stacked structure in the first direction; the first annular structure is divided by the through groove, to form two semi-annular gate dielectric layers that are located on two sides of the first via in the second direction; the second annular structure is divided by the through groove, to form two semi-annular second electrodes that are located on the two sides of the first via in the second direction; and the third annular structure is divided by the through groove, to form two semi-annular channel layers that are located on the two sides of the first via in the second direction;
manufacturing, through the through groove at locations of the first dielectric layer and the fourth dielectric layer, word lines extending in the third direction, where a part that is of the word line and that is in contact with the gate dielectric layer is a gate of the transistor;
manufacturing the penetrating pillar in the first via, where the penetrating pillar includes a bit line extending in the first direction, the bit line is in contact with the channel layer on one side, and a part that is of the bit line and that is in contact with the channel layer is a first electrode of the transistor; and
manufacturing a capacitor on a side that is of the second electrode and that is away from the penetrating pillar.

The first direction, the second direction, and the third direction are perpendicular to each other.

In some embodiments, steps of manufacturing the capacitor on the side that is of the second electrode and that is away from the penetrating pillar include:
manufacturing a second via that penetrates the initial stacked structure in the first direction; and
manufacturing a capacitor dielectric layer and a plate line at the location of the third dielectric layer through the second via, where a part that is of the plate line and that is in contact with the capacitor dielectric layer is a second capacitor plate of the capacitor.

According to a third aspect, an embodiment of this application also provides a memory, where the memory includes a controller and the three-dimensional memory array according to any one of the embodiments of the first aspect, and the controller is electrically connected to the three-dimensional memory array.

According to a fourth aspect, an embodiment of this application also provides an electronic device, where the electronic device includes a circuit board and the memory according to the embodiment of the third aspect, and the circuit board is electrically connected to the memory.

Technical effects that can be achieved by the memory and the electronic device provided in embodiments of this application are the same as the technical effects that can be achieved by the three-dimensional memory array in any one of the foregoing embodiments. Details are not described herein again.

### BRIEF DESCRIPTION OF DRAWINGS

FIG. 1 is a diagram of a structure of an electronic device according to an embodiment of this application;
FIG. 2 is a diagram of a structure of a memory according to an embodiment of this application;
FIG. 3 is a diagram of a structure of a three-dimensional memory array according to an embodiment of this application;
FIG. 4 is a diagram of a structure of a stacked structure and a penetrating pillar in FIG. 3;
FIG. 5 is a circuit diagram of a memory cell in FIG. 4;
FIG. 6 is a top view of a memory layer in FIG. 4;
FIG. 7 is an A-A' cross-sectional view in FIG. 6;
FIG. 8 is a diagram of a structure of a second electrode in FIG. 6;
FIG. 9 is an A-A' cross-sectional view of another three-dimensional memory according to an embodiment of this application;
FIG. 10 is a diagram of a structure of a second electrode and a first capacitor electrode in FIG. 9;
FIG. 11 is a diagram of a structure of a capacitor in FIG. 9;
FIG. 12 is a diagram of a structure of two memory cells whose capacitors are close to each other at a memory layer according to an embodiment of this application;
FIG. 13 is a circuit diagram of a structure in FIG. 4;
FIG. 14A to FIG. 14C are diagrams of different connection manners of a stacked structure and a word line and a bit line according to an embodiment of this application;
FIG. 15A to FIG. 15D are diagrams of different leading-out manners of a word line in a stacked structure according to an embodiment of this application;
FIG. 16 is a diagram of a structure of a stacked structure and a penetrating pillar in another three-dimensional memory array according to an embodiment of this application;
FIG. 17 is a top view of a memory layer in FIG. 16;
FIG. 18 is an A-A' cross-sectional view in FIG. 17;
FIG. 19 is a circuit diagram of a structure in FIG. 16;
FIG. 20 is a flowchart of a three-dimensional memory array preparation method according to an embodiment of this application;
FIG. 21A to FIG. 21M are diagrams of structures of the three-dimensional memory array in FIG. 3 at different manufacturing stages;
FIG. 22 is a flowchart of another three-dimensional memory array preparation method according to an embodiment of this application;
FIG. 23 is a flowchart of another three-dimensional memory array preparation method according to an embodiment of this application;
FIG. 24 is a flowchart of another three-dimensional memory array preparation method according to an embodiment of this application; and
FIG. 25 is a flowchart of another three-dimensional memory array preparation method according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms such as "second" and "first" below are only for ease of description, and cannot be understood as indicating or implying relative importance or implicitly indicating a quantity of indicated technical features. Therefore, a feature limited by "second", "first", or the like may explicitly or implicitly include one or more features. In the descriptions of this application, unless otherwise stated, "a plurality of" means two or more than two.

In addition, in embodiments of this application, orientation terms such as "up", "down", "left", and "right" may include but are not limited to definitions based on illustrated orientations in which components in the accompanying drawings are placed. It should be understood that, these directional terms may be relative concepts, are used for relative description and clarification, and may correspondingly change based on changes in the orientations in which the components in the accompanying drawings are placed in the accompanying drawings.

In embodiments of this application, unless otherwise clearly specified and limited, a term "connection" should be understood in a broad sense. For example, the "connection" may be a fixed connection, a detachable connection, or an integrated connection, or may be a direct connection or an indirect connection implemented through an intermediate medium. In addition, the term "coupling" may be a direct electrical connection, or may be an indirect electrical connection through an intermediate medium. The term "contact" may be direct contact or indirect contact through an intermediate medium.

In embodiments of this application, the term "and/or" describes an association relationship between associated objects and may indicate that three relationships exist. For example, A and/or B may indicate the following cases: Only A exists, both A and B exist, and only B exists, where A and B may be singular or plural. The character "/" generally indicates an "or" relationship between the associated objects.

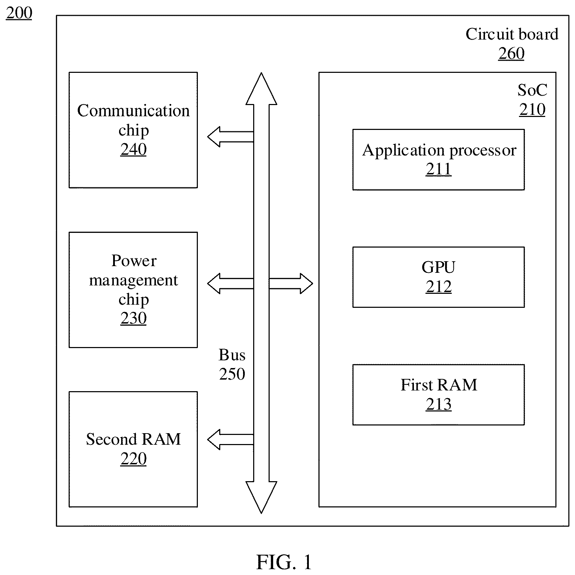

FIG. 1 shows an electronic device according to an embodiment of this application. The electronic device 200 may be a terminal device, for example, a mobile phone, a tablet computer, or a smart band, or may be a personal computer (personal computer, PC), a server, a workstation, or the like.

As shown in FIG. 1, the electronic device 200 includes a bus 250 and a system on chip (System on Chip, SoC) 210 connected to the bus 250. The SoC 210 may be configured to process data, for example, process data of an application, process image data, and cache temporary data. In some implementations, the SoC 210 may include an application processor (application processor, AP) 211 configured to process an application program, a graphics processing unit (Graphics Processing Unit, GPU) 212 configured to process image data, and a first RAM 213 configured to cache high-speed data. The first RAM 213 may be a static random access memory (Static Random Access Memory, SRAM), an embedded flash memory (embedded flash, eflash), or the like. The AP 211, the GPU 212, and the first RAM 213 may be integrated into a die (die), or may be separately disposed on a plurality of dies.

The electronic device 200 may further include a second RAM 220 connected to the SoC 210 through the bus 250. The second RAM 220 may be a dynamic random access memory (Dynamic Random Access Memory, DRAM). The second RAM 220 may be configured to store volatile data, for example, temporary data generated by the SoC 210. A storage capacity of the second RAM 220 is usually greater than that of the first RAM 213, but a read speed of the second RAM 220 is usually slower than that of the first RAM 213.

In addition, the electronic device may further include a communication chip 240 and a power management chip 230 that are connected to the SoC 210 through the bus 250. The communication chip 240 may be configured to process a protocol stack, or perform processing such as amplification and filtering on an analog radio frequency signal, or implement the foregoing functions at the same time. The power management chip 230 may be configured to supply power to another chip.

In some implementations, the SoC 210 and the second RAM 220 may be packaged in a packaging structure in a manner of, for example, 2.5D (dimension) or 3D packaging, to obtain a faster inter-chip data transmission rate.

The electronic device 200 further includes a circuit board 260 configured to carry the foregoing chips. For example, the SoC 210, the second RAM 220, the communication chip 240, and the power management chip 230 are disposed on the circuit board 260, and are electrically connected to the circuit board 260. It should be noted that the foregoing structure may be disposed on a same circuit board 260, and may be disposed on different split circuit boards 260.

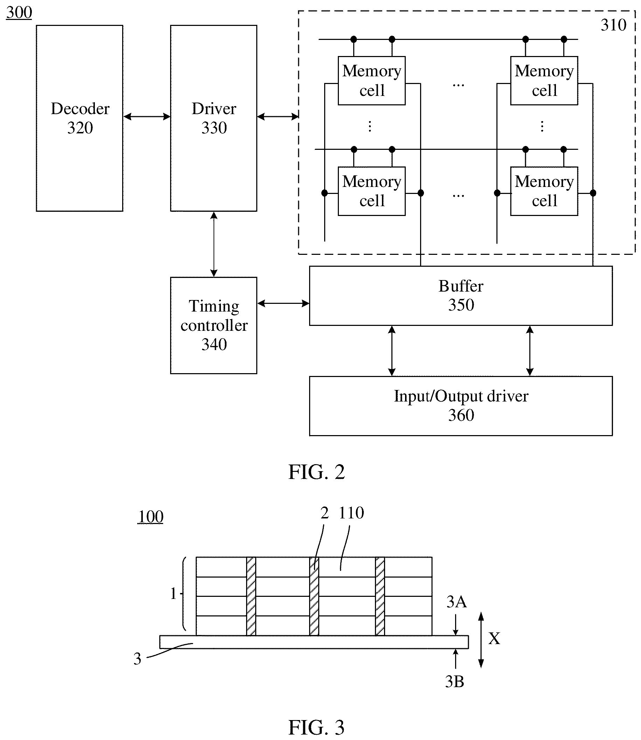

FIG. 2 is a diagram of a structure of a memory according to an embodiment of this application. The memory 300 may be different types of memories such as a dynamic random access memory (Dynamic Random Access Memory, DRAM), a static random access memory (Static Random Access Memory, SRAM), a magnetic random access memory (Magnetic Random Access Memory, MRAM), a ferroelectric random access memory (Ferroelectric Random Access Memory, FRAM), a ferroelectric field effect transistor (Ferroelectric Filed-Effect-Transistor, FeFET) memory, and a phase change memory (phase change memory, PCM). In some implementations, the memory 300 may be the first RAM 213 shown in FIG. 1, or may be the second RAM 220. An application scenario of the memory 300 is not limited in embodiments of this application.

The memory 300 includes a memory array 310, and may further include one or more circuit structures of a decoder 320, a driver 330, a timing controller 340, a buffer 350, or an input/output driver 360.

In some implementations, the memory array 310 includes a plurality of memory cells arranged in an array and a signal line connected to the memory cells. The signal line may be used to select, by receiving a control level output by a control circuit, a to-be-read/written memory cell in the memory array 310, and perform a data read/write operation. For example, the signal line may include a word line (word line, WL) and a bit line (bit line, BL).

The decoder 320 is configured to perform decoding based on a received address, to determine a memory cell that needs to be accessed. The driver 330 is configured to control a level of a signal line based on a decoding result generated by the decoder 320, to implement access to a specified memory cell. The buffer 350 is configured to buffer read data, for example, buffer the read data by using an FIFO (first-in first-out, first-in first-out). The timing controller 340 is configured to control timing of the buffer 350, and control the driver 330 to drive the signal line in the memory array 310. The input/output driver 360 is configured to drive a transmission signal, for example, drive a received data signal and drive a data signal to be sent, so that the data signals can be transmitted over long distances.

The foregoing memory array 310, the decoder 320, the driver 330, the timing controller 340, the buffer 350, and the input/output driver 360 may be integrated into one chip, or may be integrated into a plurality of chips.

An embodiment of this application also provides a three-dimensional memory array. The three-dimensional memory array may be the memory array 310 shown in FIG. 2, and is configured to form the memory 300 shown in FIG. 2, or may be configured to form another type of storage apparatus, for example, a back-end-of-line memory or an independent memory (Stand Alone Memory, SAM). An application scenario of the three-dimensional memory array is not limited in this embodiment of this application.

As shown in FIG. 3, the three-dimensional memory array 100 includes a substrate 3, a stacked structure 1, and a penetrating pillar 2. The substrate 3 may be any base material that is well known by a person skilled in the art and that is used to carry a semiconductor device. For example, the substrate 3 may be a semiconductor substrate, for example, silicon-on-insulator (silicon-on-insulator, SOI), bulk silicon (bulk silicon), germanium, germanium-silicon, gallium arsenide, or germanium-on-insulator. For another example, the substrate 3 may be made of a non-conductive material, and the non-conductive material may include, for example, glass, plastic, or a sapphire wafer.

As shown in FIG. 3, the substrate 3 includes a first surface and a second surface that are disposed opposite to each other in a first direction X. An orientation shown in FIG. 3 is used as an example. The first direction X is a longitudinal direction, and the first surface 3A and the second surface 3B are disposed opposite to each other up and down. The first surface 3A is an upper surface of the substrate 3, and the second surface 3B is a lower surface of the substrate 3.

It should be noted that, although the three-dimensional memory array 100 in this embodiment includes the substrate 3, in some three-dimensional memory arrays 100, the substrate 3 is a process structure in a manufacturing process of the three-dimensional memory array 100, and a final product does not have the substrate 3. In other words, the three-dimensional memory array 100 provided in this embodiment of this application may not include the substrate 3.

The three-dimensional memory array 100 is provided with the stacked structure 1 and a plurality of penetrating pillars 2 on an outer side of the first surface 3A in the substrate 3. The stacked structure 1 includes a plurality of memory layers 110 that are stacked in the first direction X, and the memory layers 110 include word lines. The penetrating pillar 2 extends in the first direction X and penetrates the stacked structure 1. The penetrating pillar 2 includes a bit line extending in the first direction X, and the bit line penetrates the stacked structure 1 along the penetrating pillar 2 in the first direction X.

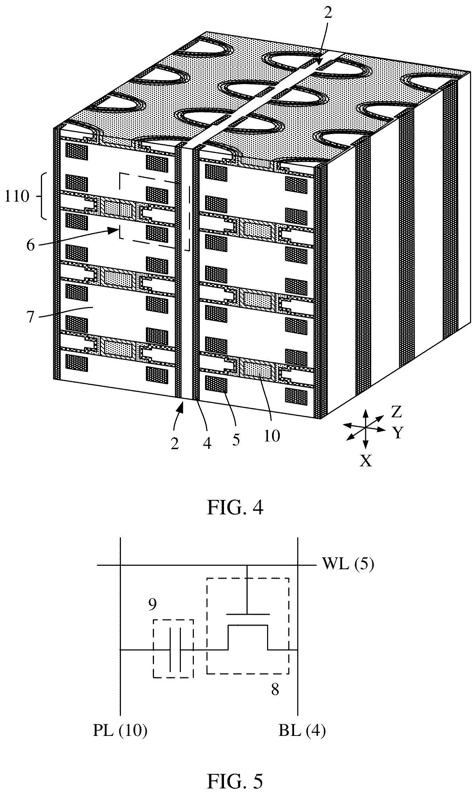

FIG. 4 is a diagram of a structure of a stacked structure 1 and a penetrating pillar 2 in FIG. 3. FIG. 5 is a circuit diagram of a memory cell 6 in FIG. 4. As shown in FIG. 4 and FIG. 5, the memory layer 110 of the stacked structure 1 includes a plurality of memory cells 6 that are arranged in an array and that are in a same plane parallel to the substrate 3. The memory cell 6 adopts an 1T1C (1-transistor-1-capacitor) architecture, and includes a transistor 8 and a capacitor 9. The transistor 8 in the memory cell 6 may be a metal-oxide-semiconductor field-effect transistor (metal-oxide-semiconductor field-effect transistor, MOSFET or MOS transistor for short), and includes a gate, a first electrode, and a second electrode. The first electrode is one of a source (Source) and a drain (Drain), and the second electrode is the other of the source and the drain.

In this embodiment, the three-dimensional memory array 100 is described by using an example in which the first electrode is a source and the second electrode is a drain. In some other embodiments, the first electrode may be a drain, and the second electrode may be a source.

As shown in FIG. 5, the gate of the transistor 8 is connected to a word line 5, the first electrode is connected to a bit line 4, the second electrode is connected to a capacitor plate of the capacitor 9, and another capacitor plate of the capacitor 9 is connected to a plate line (plate line, PL) 10. In the memory cell 6, the transistor 8 is configured to determine whether to "select" the memory cell 6 through conduction and cut-off, and the capacitor 9 is configured to store data. In a data read/write process of the memory cell 6, the transistor 8 in the corresponding memory cell 6 may be controlled to be conducted through the word line 5, to select the corresponding memory cell 6; and data writing, reading, and erasing are performed on the capacitor 9 in the selected memory cell 6 through the bit line 4.

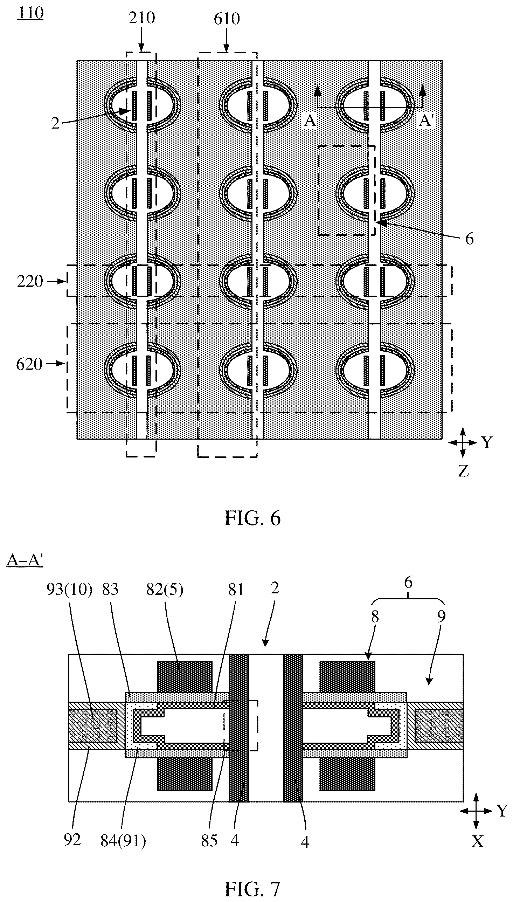

FIG. 6 is a top view of the memory layer 110 in FIG. 4. As shown in FIG. 6, at the memory layer 110, two memory cells 6 are disposed corresponding to one penetrating pillar 2. In an outer circumferential region of the penetrating pillar 2, the two memory cells 6 corresponding to the penetrating pillar 2 are disposed opposite to each other on two sides of the penetrating pillar 2 in a second direction Y, and are respectively connected to bit lines 4 in the penetrating pillar 2. The second direction Y is parallel to the memory layer 110, and is perpendicular to the first direction X. It should be noted that the penetrating pillar 2 is of a columnar structure extending in the first direction X, and has an outer circumferential surface parallel to the first direction X. The outer circumferential region herein is a region that covers an outer side of the outer circumferential surface of the penetrating pillar 2.

In this design, in comparison with a solution in which one memory cell corresponding to one penetrating pillar is disposed at each memory layer in a related technology, in the three-dimensional memory array 100 in this embodiment of this application, more memory cells 6 can be disposed at the memory layer 110 when a same layout of the penetrating pillar 2 is used, so that storage density and a storage capacity of the three-dimensional memory array 100 are improved.

In addition, the two memory cells 6 corresponding to the penetrating pillar 2 are disposed opposite to each other on the two sides of the penetrating pillar 2 in the second direction, so that space of the outer circumferential region of the penetrating pillar 2 can be appropriately used. Each memory cell 6 can be disposed at a location that is close to the corresponding penetrating pillar 2, so that a total area occupied by the two memory cells 6 corresponding to the penetrating pillar 2 at the memory layer can be reduced, more penetrating pillars 2 and memory cells 6 can be disposed in a same area, and storage density and a storage capacity of the three-dimensional memory array 100 are improved.

In some embodiments, the two memory cells 6 corresponding to the penetrating pillar 2 are disposed opposite to each other in the outer circumferential region of the penetrating pillar 2 in the second direction Y, and are of a symmetric structure relative to the penetrating pillar 2. The following uses the penetrating pillar 2 and the two memory cells 6 that are at the memory layer 110 and that correspond to the penetrating pillar 2 as an example to describe structures and connection relationships of the memory layer 110, the memory cell 6, and the penetrating pillar 2.

With reference to FIG. 7, the penetrating pillar 2 includes two bit lines 4 that are disposed at an interval in the second direction Y, and insulation isolation is implemented between the two bit lines 4 by using a dielectric material. The two memory cells 6 corresponding to the penetrating pillar 2 are disposed opposite to each other on the two sides of the penetrating pillar 2 in the second direction Y, and each memory cell 6 is connected to a bit line 4 that is on a same side of the memory cell 6 and that is in the penetrating pillar 2.

The two memory cells 6 located on the two sides of the penetrating pillar 2 may be of a symmetric structure relative to the penetrating pillar 2. In this design, manufacturing of the memory cells 6 can be facilitated, and the two memory cells 6 can be disposed in the peripheral space of the penetrating pillar 2, so that storage density of the three-dimensional memory array 100 is improved.

A memory cell 6 located on one side of the penetrating pillar 2 is used as an example. A transistor 8 in the memory cell 6 includes a channel layer 81, a gate 82, a gate dielectric layer 83, a first electrode 85, and a second electrode 84.

The channel layer 81 is of a semi-annular structure that extends around the penetrating pillar 2 in the outer circumferential region of the penetrating pillar 2, and a material of the channel layer 81 includes one or a combination of semiconductor materials such as silicon (Si), polycrystalline silicon (poly-Si, p-Si), amorphous silicon (amorphous-Si, a-Si), indium gallium zinc oxide (In-Ga-Zn-O, IGZO) multi-element compound, zinc oxide (ZnO), molybdenum dioxide (MoS2), and tungsten dioxide (WS2).

In some embodiments, the channel layer 81 is a semiconductor thin film disposed on a surface of a dielectric material.

The channel layer 81 includes a first channel surface and a second channel surface that are disposed opposite to each other in the first direction X. The orientation shown in FIG. 7 is used as an example. The first channel surface is an upper surface of the channel layer 81, and the second channel surface is a lower surface of the channel layer 81.

The gate dielectric layers 83 are disposed on outer sides of the first channel surface and the second channel surface of the transistor 8 in the channel layer 81, the gate dielectric layer 83 is in contact with the channel layer 81, and a material of the gate dielectric layer 83 includes one or a combination of dielectric materials such as silicon oxide (SiO2), aluminum oxide (Al2O3), hafnium oxide (HfO₂), zirconium oxide (ZrO₂), titanium oxide (TiO₂), yttrium oxide (Y₂O₃), and silicon nitride (Si₃N₄). The gate dielectric layer 83 may be of a single-layer structure, or may be of a laminated structure. Corresponding to the semi-annular structure of the channel layer 81, the gate dielectric layer 83 may also be of a semi-annular structure extending around the penetrating pillar 2 in the outer circumferential region of the penetrating pillar 2.

The gate 82 of the transistor 8 is disposed on a side that is of the gate dielectric layer 83 and that is away from the channel layer 81 in the first direction X, and the gate 82 is in contact with the gate dielectric layer 83. The gate dielectric layer 83 isolates the channel layer 81 and the gate 82. The gate 82 of the transistor 8 is electrically connected to the word line 5 at the memory layer 110. A material of the gate 82 is a conductive material, and the conductive material may be polycrystalline silicon or a metal material. For example, the material of the gate 82 may include one or a combination of conductive materials such as tungsten (W), titanium (Ti), gold (Au), molybdenum (Mo), aluminum (Al), copper (Cu), ruthenium (Ru), silver (Ag), titanium nitride (TiN), and indium tin oxide (In-Ti-O, ITO).

In this embodiment, the gate 82 in the transistor 8 includes a top gate and a bottom gate that are disposed on two sides of the channel layer 81 in the first direction X, to form the transistor 8 having a dual-gate structure. The transistor 8 is designed to have a dual-gate structure, so that a control capability of the transistor 8 can be improved.

In some other embodiments, the gate dielectric layer 83 and the gate 82 may be located only on one side of the channel layer 81. In other words, an outer side of the first channel surface or the second channel surface in the channel layer 81, to form a transistor 8 of a single-gate structure. The transistor 8 of the single-gate structure may simplify a structure of the memory cell 6, and reduce a size of the memory cell 6 in the first direction X, so that storage density of the three-dimensional memory array 100 is improved.

With reference to FIG. 7, the first electrode 85 and the second electrode 84 in the transistor 8 are disposed on the two sides of the channel layer 81 in the second direction Y, and are in contact with the channel layer 81 respectively. The first electrode 85 is close to the penetrating pillar 2 relative to the second electrode 84, and is connected to the bit line 4 that is in the penetrating pillar 2 and that is close to a side of the memory cell 6. The second electrode 84 is far away from the penetrating pillar 2 relative to the first electrode 85, and is connected to the capacitor 9.

Materials of the first electrode 85 and the second electrode 84 are both conductive materials, for example, metal materials. For example, the materials of the first electrode 85 and the second electrode 84 may include one or a combination of conductive materials such as tungsten (W), titanium (Ti), gold (Au), molybdenum (Mo), aluminum (Al), copper (Cu), ruthenium (Ru), silver (Ag), titanium nitride (TiN), and indium tin oxide (In-Ti-O, ITO). The material of the first electrode 85 may be the same as or different from the material of the second electrode 84.

In this embodiment, the first electrode 85 and the bit line 4 in the penetrating pillar 2 are of an integrated structure. In other words, a part of the bit line 4 in the penetrating pillar 2 that is in contact with the channel layer 81 is also constructed as the first electrode 85 of the transistor 8. In this design, a size of the memory cell 6 in the second direction Y can be reduced, and this is conducive to miniaturization of the memory cell 6, so that storage density of the three-dimensional memory array 100 is improved.

In some other embodiments, the first electrode 85 and the bit line 4 in the penetrating pillar 2 may be two independent structures that are electrically connected to each other. In this case, corresponding to the structure of the channel layer 81, the first electrode 85 may be of a semi-annular structure extending around the penetrating pillar 2 in the outer circumferential region of the penetrating pillar 2.

The second electrode 84 is disposed, relative to the first electrode 85, on a side that is of the channel layer 81 and that is away from the penetrating pillar 2, and is in contact with the channel layer 81. Corresponding to the structure of the channel layer 81, the second electrode 84 may be of a semi-annular structure extending around the penetrating pillar 2 in the outer circumferential region of the penetrating pillar 2.

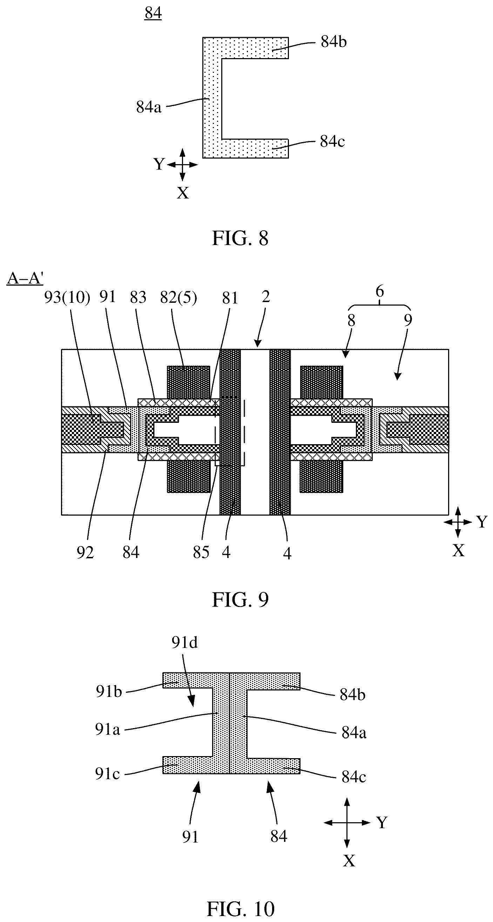

In some embodiments, as shown in FIG. 7 and FIG. 8, the second electrode 84 is snap-fit on an outer circumferential edge of the channel layer 81, and includes a first part 84a, a second part 84b, and a third part 84c. The first part 84a is parallel to the first direction X and is in contact with the outer circumferential surface of the channel layer 81. The second part 84b and the third part 84c are respectively disposed at two ends of the first part 84a in the first direction X, and extend towards the channel layer 81 in the second direction Y. The second part 84b and the third part 84c are respectively in contact with two opposite side surfaces of the channel layer 81 in the first direction X. The first part 84a, the second part 84b, and the third part 84c form the second electrode 84 in a "C" shape. In this design, a contact area between the second electrode 84 and the channel layer 81 can be increased, so that performance of the transistor 8 is improved.

The transistor 8 is designed with a semi-annular structure, so that a device size of the transistor 8 is reduced while normal performance of the transistor 8 is ensured, a size of the memory cell 6 is reduced, and storage density of the three-dimensional memory array 100 is improved.

With reference to FIG. 7, in the second direction Y, the capacitor 9 is disposed on a side that is of the memory cell 6 and that is away from the penetrating pillar 2. The capacitor 9 includes a first capacitor plate 91, a capacitor dielectric layer 92, and a second capacitor plate 93 that are arranged in the second direction Y. The first capacitor plate 91 is connected to the second electrode 84 in the transistor 8, the second capacitor plate 93 is connected to the plate line 10, and the capacitor dielectric layer 92 is disposed in a gap between the first capacitor plate 91 and the second capacitor plate 93.

The capacitor 9 and the transistor 8 in the memory cell 6 are disposed in the second direction Y. Such a design helps reduce a height of the memory cell 6 in the first direction X, so that a thickness of the memory layer 110 is reduced, and storage density of the three-dimensional memory array 100 is improved.

Materials of the first capacitor plate 91 and the second capacitor plate 93 are both conductive materials, for example, metal materials. For example, the materials of the first capacitor plate 91 and the second capacitor plate 93 may include one or a combination of conductive materials such as tungsten (W), titanium (Ti), gold (Au), molybdenum (Mo), aluminum (Al), copper (Cu), ruthenium (Ru), silver (Ag), titanium nitride (TiN), and indium tin oxide (In-Ti-O, ITO). The material of the first capacitor plate 91 may be the same as or different from the material of the second capacitor plate 93.

A material of the capacitor dielectric layer 92 includes any one of a ferroelectric material, an insulation material, a phase change material, a resistive material, or a ferromagnetic material. Different types of memories may be formed based on different materials of the capacitor dielectric layer 92.

The ferroelectric material used to form the capacitor dielectric layer 92 may include zirconium oxide (ZrO₂), hafnium oxide (HfO₂), zirconium hafnium oxide (ZrHfOₓ), Al-doped HfO₂, Si-doped HfO₂, Zr-doped HfO₂, La-doped HfO₂, and Y-doped HfO₂, and one or more of materials that are doped with another element based on the foregoing materials. When the material of the capacitor dielectric layer 92 is the ferroelectric material, a memory formed by the memory cell 6 may be a ferroelectric memory (for example, a ferroelectric random access memory and a ferroelectric field effect transistor).

The insulation material used to form the capacitor dielectric layer 92 may include one or a combination of high K dielectric materials such as aluminum oxide (Al₂O₃), zirconium oxide (ZrO₂), titanium oxide (TiO₂), hafnium oxide (HfO₂), silicon oxide (SiO₂), silicon nitride (Si₃N₄), yttrium oxide (Y₂O₃), and lanthanum oxide (La₂O₃). When the material of the capacitor dielectric layer 92 is the insulation material, a memory formed by the memory cell 6 may be a dynamic random access memory.

The phase change material used to form the capacitor dielectric layer 92 may include a sulfur compound thin film or a combination of a plurality of sulfur compound thin films. When the material of the capacitor dielectric layer 92 is the phase change material, a memory formed by the memory cell 6 may be a phase change memory.

The resistive material used to form the capacitor dielectric layer 92 may include a binary transition metal oxide (TMO), for example, a resistive material like chromium oxide (HfOₓ) and tantalum oxide (TaOₓ). When the material of the capacitor dielectric layer 92 is the resistive material, a memory formed by the memory cell 6 may be a resistive random access memory.

The ferromagnetic material used to form the capacitor dielectric layer 92 may include, for example, one or a combination of iridium manganese (IrMn), platinum manganese (PtMn), ferromanganese (FeMn), ruthenium manganese (RuMn), nickel manganese (NiMn), and palladium platinum manganese (PdPtMn). When the material of the capacitor dielectric layer 92 is the ferromagnetic material, a memory formed by the memory cell 6 may be a magnetic random access memory.

In this embodiment, as shown in FIG. 7, the second electrode 84 and the first capacitor plate 91 in the capacitor 9 are of an integrated structure. In other words, the first electrode 85 is a drain of the transistor 8 and an electrode plate of the capacitor 9. Such a design can simplify a structure of the memory cell 6 and reduce a size of the memory cell 6 in the second direction Y, so that storage density of the three-dimensional memory array 100 is improved.

It can be learned from the foregoing descriptions that the second electrode 84 is of a semi-annular structure extending around the penetrating pillar 2. In other words, for the capacitor 9, the first capacitor plate 91 is of a semi-annular structure extending around the penetrating pillar 2. In addition, the second capacitor plate 93 and the capacitor dielectric layer 92 in the capacitor 9 may alternatively be of semi-annular structures extending around the penetrating pillar 2.

In some other implementations, as shown in FIG. 9 to FIG. 11, the second electrode 84 and the first capacitor plate 91 in the capacitor 9 may be independent structures that are electrically connected to each other. In this case, the first capacitor plate 91, the second capacitor plate 93, and the capacitor dielectric layer 92 in the capacitor 9 may all be of semi-annular structures that extend around the penetrating pillar 2 in the outer circumferential region of the penetrating pillar 2.

The capacitor 9 is designed with a semi-annular structure, so that a capacitance value of the capacitor 9 in a small size is increased, a size of the memory cell 6 is reduced while normal working of the memory cell 6 is ensured, and storage density of the three-dimensional memory array 100 is improved.

In some embodiments, the first capacitor plate 91 has a fitting groove with an opening facing the second capacitor plate 93; the second capacitor plate includes a fitting part extending into the fitting groove, and the capacitor dielectric layer 92 is disposed in a gap between the fitting groove and the fitting part. In this way, a contact area between the capacitor plate and the capacitor dielectric layer 92 can be increased, so that capacitance of the capacitor 9 is increased.

The first capacitor plate 91 designed with the fitting groove may be of an integrated structure with the second electrode 84, or may be of an independent structure relative to the second electrode 84.

For example, as shown in FIG. 9 to FIG. 11, the second electrode 84 and the first capacitor plate 91 are independent structures that are electrically connected to each other. A structure of the second electrode 84 is shown in FIG. 8. The first capacitor plate 91 includes a fourth part 91a, a fifth part 91b, and a sixth part 91c. The fourth part 91a extends in the first direction X, and the fifth part 91b and the sixth part 91c are disposed opposite to each other at two ends of the fourth part 91a in the first direction X, and extend toward the second capacitor plate 93 in the second direction Y. The fourth part 91a, the fifth part 91b, and the sixth part 91c form the fitting groove 91d through limitation.

As shown in FIG. 10, when the first capacitor plate 91 is electrically connected to the second electrode 84, the fourth part 91a is in contact with the first part 84a, the second part 84b is opposite to the fifth part 91b and extends in an opposite direction, and the third part 84c is opposite to the sixth part 91c and extends in an opposite direction, so that the second electrode 84 and the first capacitor plate 91 form an X-shaped structure.

In the foregoing embodiment, at least a part of structures of the memory cell 6 are of semi-annular structures extending around the penetrating pillar 2 in the outer circumferential region of the penetrating pillar 2, for example, the channel layer 81, the gate dielectric layer 83, the second electrode 84 (the first capacitor plate 91), the capacitor dielectric layer 92, and the second capacitor plate 93. The semi-annular structure herein refers to an arc, an ellipse arc, or a curve that is an orthographic projection of a shape of a structure on a reference surface perpendicular to the first direction X and that extends around a center by a specific angle, where the center is a location of the penetrating pillar 2 (for example, a center line of the penetrating pillar 2). An extension angle of the semi-annular structure around the penetrating pillar 2 may be any angle, and extension angles of different semi-annular structures may be the same or may be different. For example, in this embodiment, an extension angle of the semi-annular structure may be 60 degrees to 175 degrees, and extension angles of different semi-annular structures are the same or basically the same.

The memory cell 6 adopts a semi-circular design, so that manufacturing of the memory cell 6 is facilitated, and a straight structure is replaced with a curved structure. In this way, a size of the memory cell 6 can be reduced while normal performance of the memory cell 6 is ensured, and storage density of the three-dimensional memory array 100 is improved.

The foregoing is a description of a memory cell 6 located on one side of the penetrating pillar 2. For another memory cell 6 located on the other side of the penetrating pillar 2, refer to the foregoing described memory cell 6 for symmetric settings, and details are not described herein again.

With reference to FIG. 6, the penetrating pillar 2 is arranged in an array of a plurality of rows and a plurality of columns in the memory layer 110, including a plurality of penetrating pillar rows 210 arranged in the second direction Y and a plurality of penetrating pillar columns 220 arranged in a third direction Z. The penetrating pillar rows 210 include a plurality of penetrating pillars 2 arranged in the third direction Z, and the penetrating pillar columns 220 include a plurality of penetrating pillars 2 arranged in the second direction Y. A direction of the penetrating pillar rows 210 is parallel to the third direction Z, a direction of the penetrating pillar columns 220 is located is parallel to the second direction Y. Both the second direction Y and the third direction Z are perpendicular to the first direction X, and the second direction Y and the third direction Z may be perpendicular to each other, or may be arranged at an included angle between 0 degrees and 90 degrees. In this embodiment, an example in which the first direction X, the second direction Y, and the third direction Z are perpendicular to each other is used to describe the solution.

It can be learned from the foregoing descriptions that two memory cells 6 corresponding to one penetrating pillar 2 are disposed in the memory layer 110, and the two memory cells 6 are disposed in an outer circumferential region corresponding to the penetrating pillar 2 in the second direction Y, and are respectively connected to bit lines 4 in the penetrating pillar 2. With reference to a relationship between the memory cell 6 and the penetrating pillar 2, it can be learned that the memory cell 6 is also arranged in an array of a plurality of rows and a plurality of columns in the memory layer 110, including a plurality of memory cell rows 610 arranged in the second direction Y and a plurality of memory cell columns 620 arranged in the third direction Z. The memory cell rows 610 include a plurality of memory cells 6 arranged in the third direction Z, and a direction of the memory cell rows 610 is parallel to the third direction Z. The memory cell columns 620 include a plurality of memory cells 6 arranged in the second direction Y, and a direction of the memory cell columns 620 is parallel to the second direction Y. In addition, every two memory cell rows 610 correspond to one penetrating pillar row 210, and two memory cell rows 610 corresponding to a same penetrating pillar row 210 are disposed on two sides of the corresponding penetrating pillar row 210 in the second direction Y.

As shown in FIG. 4 to FIG. 7, the memory layer 110 further includes a plurality of word lines 5 spaced from each other in the second direction Y, and an extension direction of the word lines 5 is parallel to the third direction Z, that is, parallel to an extension direction of the memory cell row 610. Memory cells 6 in a same memory cell row 610 are connected to a same word line 5.

In this embodiment, in a same memory cell row 610, gates 82 of the transistors 8 in the memory cells 6 are connected in the third direction Z to form a word line 5, and the word line 5 and the gates 82 of the transistors 8 are of an integrated structure. In other words, a part that is of the word line 5 and that is in contact with the gate dielectric layer 83 is configured as the gate 82 of the transistor 8. In this design, a structure of the memory cell 6 can be simplified, a size of the memory cell 6 in the memory layer 110 is reduced, and storage density of the three-dimensional memory array 100 is provided.

In some other embodiments, the gate 82 and the word line 5 of the transistor 8 in the memory cell 6 may be two structures that are electrically connected to each other.

As shown in FIG. 4 to FIG. 7, the memory layer 110 further includes a plurality of plate lines 10 spaced from each other in the second direction Y, and an extension direction of the plate lines 10 is parallel to the third direction Z, that is, parallel to an extension direction of the memory cell row 610. Memory cells 6 in a same memory cell row 610 are connected to a same plate line 10.

In this embodiment, in the same memory cell row 610, the second capacitor plates 93 of the capacitor 9 in the memory cell 6 are connected in the third direction Z to form the plate line 10, and the plate line 10 and the second capacitor plate 93 of the capacitor 9 are of an integrated structure. In other words, a part of the plate line 10 in contact with the capacitor dielectric layer 92 is configured as the second capacitor plate 93. In this design, a structure of the memory cell 6 can be simplified, a size of the memory cell 6 in the memory layer 110 is reduced, and storage density of the three-dimensional memory array 100 is provided.

In some other embodiments, the second capacitor plate 93 of the capacitor 9 in the memory cell 6 and the plate line 10 may be two structures that are electrically connected to each other.

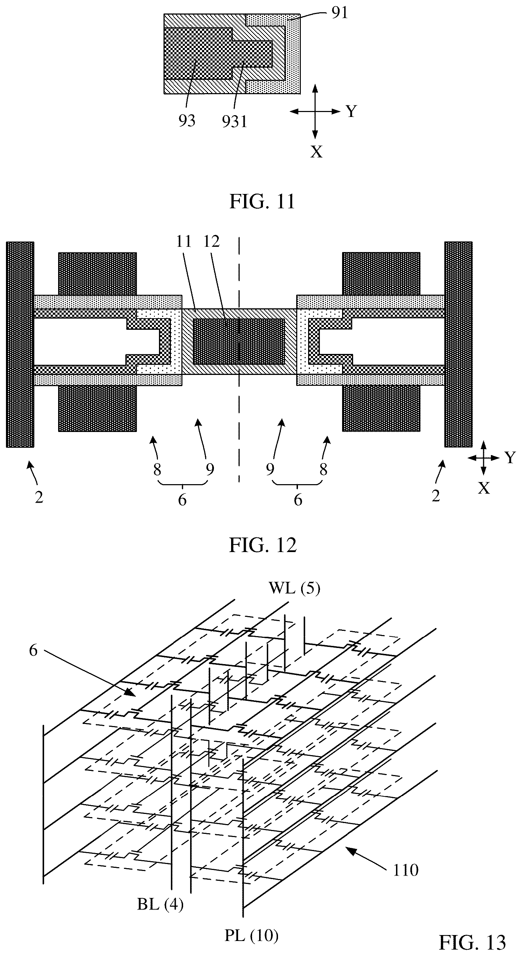

A same memory cell column 620 at the memory layer 110 includes a plurality of memory cells 6 disposed in the second direction Y, and the plurality of memory cells 6 include two adjacent memory cells 6 located between two adjacent penetrating pillars 2. As shown in FIG. 12, in the two adjacent memory cells 6, capacitors 9 are close to each other, and second capacitor plates 93 in the capacitor 9 are close to each other. Based on this, in some embodiments, the two second capacitor plates 93 that are close to each other are of an integrated structure, and are connected to a same plate line 10. In other words, two memory cell rows 610 located between two adjacent penetrating pillar rows 210 may share one plate line 10.

For example, in this embodiment, a metal extension part 12 extending in the third direction Z is disposed at a location between two adjacent penetrating pillar rows 210 at the memory layer 110, and the metal extension part 12 is used as a plate line 10 of two memory cell rows 610 located between the two adjacent penetrating pillar rows 210.

The metal extension part 12 includes a plate part, where the plate part is a part that is of the metal extension part 12 and that corresponds to the memory cell 6, and is used as a second capacitor plate 93 of the capacitor 9 in the two memory cells 6 between the two penetrating pillars 2. A dielectric surrounding layer 11 is further wrapped around the plate part, and the dielectric surrounding layer 11 is used as a capacitor dielectric layer 92 of the capacitor 9.

The above provides some descriptions about the memory layer 110. With reference to FIG. 3 and FIG. 4, the plurality of memory layers 110 that are stacked in the first direction X can form a three-dimensional memory array 100. A quantity of stacked memory layers 110 in the stacked structure 1 is not specifically limited in this embodiment of this application. It can be learned from the foregoing descriptions of the memory layer 110 that a quantity of stacked memory layers 110 in the stacked structure 1 affects a quantity of memory cells 6 in the three-dimensional memory array 100, that is, a size of a storage capacity. A larger quantity of stacked memory layers 110 in the stacked structure 1 indicates a higher integration, a larger quantity of memory cells 6 in formed the three-dimensional memory array 100, and a larger storage capacity. In different implementations, the stacked structure 1 may have different stacked layers, for example, may be 8, 32, 64, or 128 layers.

The three-dimensional memory array 100 further includes a plate line column, and the plate line column penetrates the stacked structure 1 at the location of the plate line 10 at the memory layer 110 in the first direction X, to connect plate lines 10 of different memory layers 110.

FIG. 13 shows a circuit diagram of the foregoing three-dimensional memory array 100. As shown in FIG. 13, the memory layer 110 includes the memory cell 6 and the word line 5, where the word line 5 is connected to a memory cell 6 at a corresponding location at the memory layer 110. The bit line 4 penetrates the memory layer 110 in the stacked structure 1 in the first direction X, and is connected to memory cells 6 at a same location at different memory layers 110. The plate line 10 includes a part located at the memory layer 110 and a part that penetrates the stacked structure 1. The plate line 10 located at the memory layer 110 is connected to the memory cell 6 at a corresponding location, and the plate line 10 that penetrates the stacked structure 1 is connected to the plate lines 10 at different memory layers 110.

With reference to FIG. 4, the three-dimensional memory array 100 further includes an insulation spacer layer 7. The insulation spacer layer 7 implements insulation isolation between memory layers 110 and between adjacent memory cells 6. A material of the insulation spacer layer includes one or a combination of dielectric materials, such as aluminum oxide (Al₂O₃), zirconium oxide (ZrO₂), titanium oxide (TiO₂), hafnium oxide (HfO₂), silicon oxide (SiO₂), silicon nitride (Si₃N₄), and yttrium oxide (Y₂O₃).

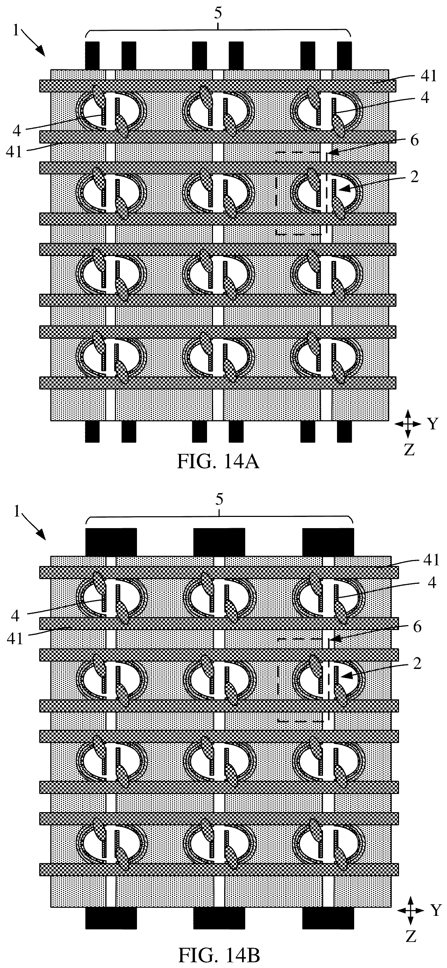

As shown in FIG. 14A to FIG. 14C, the three-dimensional memory array 100 further includes a plurality of bit line connection lines 41 located outside the stacked structure 1. The bit line connection lines 41 extend in the second direction Y in an outer region of a top (an end away from the substrate 3) of the penetrating pillar 2, and the plurality of bit line connection lines 41 are arranged in the third direction Z.

In some embodiments, as shown in FIG. 14A and FIG. 14B, two bit line connection lines 41 are disposed corresponding to one penetrating pillar column 220, and are distributed in the third direction Z on two sides of the penetrating pillar column 220. One bit line connection line 41 is connected to one bit line 4 that penetrates the penetrating pillar 2 in the penetrating pillar column 220, and the other bit line connection line 41 is connected to another bit line 4 that penetrates the penetrating pillar 2 in the penetrating pillar column 220. In this way, corresponding bit lines 4 in different penetrating pillars 2 in the same penetrating pillar column 220 are connected in the second direction Y.

In this case, as shown in FIG. 14A, the two memory cells 6 corresponding to the same penetrating pillar 2 may be connected to different word lines 5. As shown in FIG. 14B, two memory cells 6 corresponding to the same penetrating pillar 2 may also be connected to a same word line 5. Herein, the same word line 5 may be implemented inside the stacked structure 1, or may be implemented outside the stacked structure 1 by using a conductor structure.

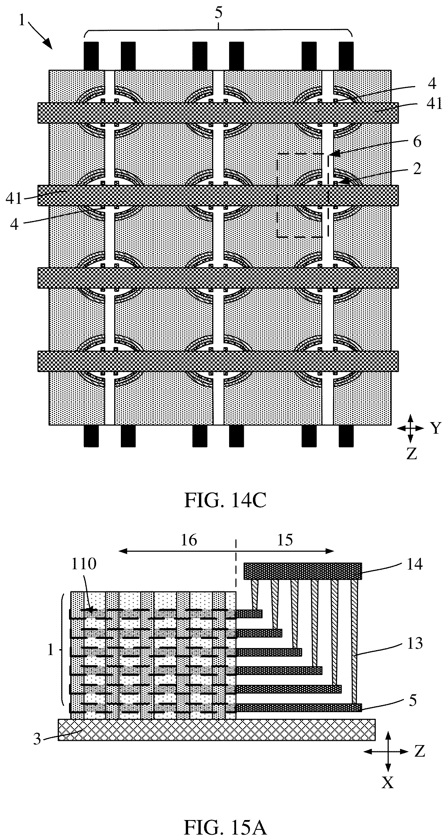

In some other embodiments, as shown in FIG. 14C, one bit line connection line 41 is disposed corresponding to one penetrating pillar column 220, and two bit lines 4 of the penetrating pillar 2 in the penetrating pillar column 220 are connected to a same bit line connection line 41, so that two bit lines 4 in different penetrating pillars 2 in the same penetrating pillar column 220 are connected in the second direction Y. In this case, the two memory cells 6 corresponding to the same penetrating pillar 2 are connected to different word lines 5.

It can also be seen from the foregoing descriptions that connection manners between the two memory cells 6 corresponding to the penetrating pillar 2 and the word line 5 and the bit line 4 include:
the two memory cells 6 are connected to different word lines 5 and different bit lines 4;
the two memory cells 6 are connected to a same word line 5 and different bit lines 4; and
the two memory cells 6 are connected to different word lines 5 and a same bit line 4.

In some embodiments, as shown in FIG. 15A to FIG. 15D, the stacked structure 1 in the three-dimensional memory array 100 includes an array region 16 and an electrical connection region 15 in the third direction Z. The memory cell 6 is located in the array region 16, and the word line 5 extends from the array region 16 to the electrical connection region 15. The three-dimensional memory array 100 further includes an interconnection structure 14 and a plurality of interconnection contacts 13. The interconnection structure 14 may be used to connect to a peripheral circuit. One end of the interconnection contact 13 is connected to the interconnection structure 14, and the other end of the interconnection contact 13 is connected to the word line 5 in the electrical connection region 15.

Connection manners between the word line 5, the interconnection contact 13, and the interconnection structure 14 may include the following manners.

As shown in FIG. 15A, the interconnection structure 14 is disposed in a top region that is of the stacked structure 1 and that is away from the substrate 3, and the memory layers 110 in the stacked structure 1 extend in the third direction Z, to form a step structure in the electrical connection region 15. In the step structure, a memory layer 110 close to the substrate 3 extends for a longer distance than a memory layer 110 away from the substrate 3. Therefore, by using the step structure, word lines 5 at different memory layers 110 may be exposed to the interconnection structure 14, and the interconnection structure 14 is connected to the word lines 5 in the electrical connection region 15 through the interconnection contacts 13 extending in the first direction X.

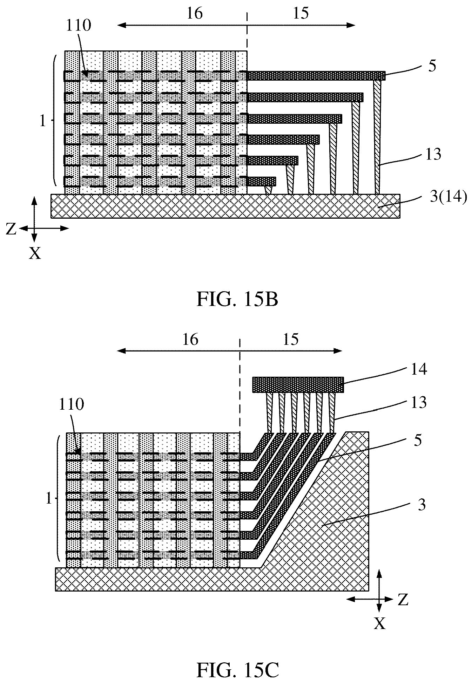

As shown in FIG. 15B, the interconnection structure 14 is disposed in a bottom region that is of the stacked structure 1 and that is away from the substrate 3. The interconnection structure 14 may be located in the substrate 3, or may be located on a side that is of the substrate 3 and that is opposite to the stacked structure 1. In this embodiment, an example in which the interconnection structure 14 is located in the substrate 3 is used for description.

The memory layers 110 in the stacked structure 1 extend in the third direction Z, to form a step structure in the electrical connection region 15. In the step structure, a memory layer 110 close to the substrate 3 extends for a shorter distance than a memory layer 110 away from the substrate 3. Therefore, by using the step structure, word lines 5 at different memory layers 110 may be exposed to the interconnection structure 14, and the interconnection structure 14 is connected to the word lines 5 in the electrical connection region 15 through the interconnection contacts 13 extending in the first direction X.

As shown in FIG. 15C, the interconnection structure 14 is disposed in a top region that is of the stacked structure 1 and that is away from the substrate 3, and the word line 5 in the memory layer 110 extends in the electrical connection region 15 and is exposed on a surface that is of the electrical connection region 15 and that is close to the interconnection structure 14. The interconnection contact 13 extends in the first direction X, and is connected to the interconnection structure 14 and the word line 5. The word line 5 in the electrical connection region 15 may extend in a manner parallel to the third direction Z and the first direction X, or may extend in a manner inclined to the first direction X and the second direction Y. For example, in this embodiment, the word line 5 obliquely extends upward to a surface that is of the electrical connection region 15 and that is close to the interconnection structure 14.

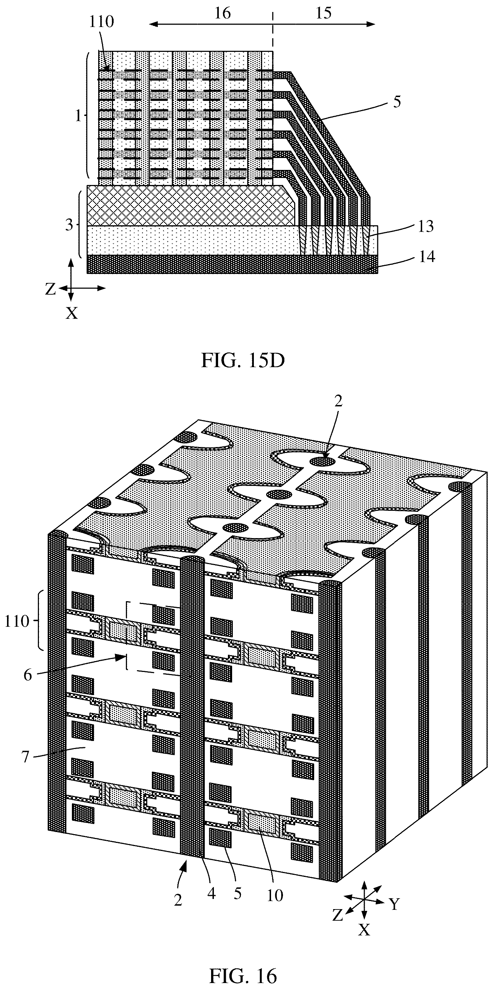

As shown in FIG. 15D, the interconnection structure 14 is disposed in a bottom region that is of the stacked structure 1 and that is away from the substrate 3. The interconnection structure 14 may be located in the substrate 3, or may be located on a side that is of the substrate 3 and that is opposite to the stacked structure 1. In this embodiment, an example in which the interconnection structure 14 is located on a side that is of the substrate 3 and that is opposite to the stacked structure 1 is used for description. The word line 5 in the memory layer 110 extends in the electrical connection region 15, and is exposed on a surface that is of the electrical connection region 15 and that is close to the interconnection structure 14. The interconnection contact 13 extends in the first direction X, and is connected to the interconnection structure 14 and the word line 5.

The word line 5 in the electrical connection region 15 may extend in a manner parallel to the third direction Z and the first direction X, or may extend in a manner inclined to the first direction X and the second direction Y. For example, in this embodiment, the word line 5 obliquely extends downward to a surface that is of the electrical connection region 15 and that is close to the interconnection structure 14.

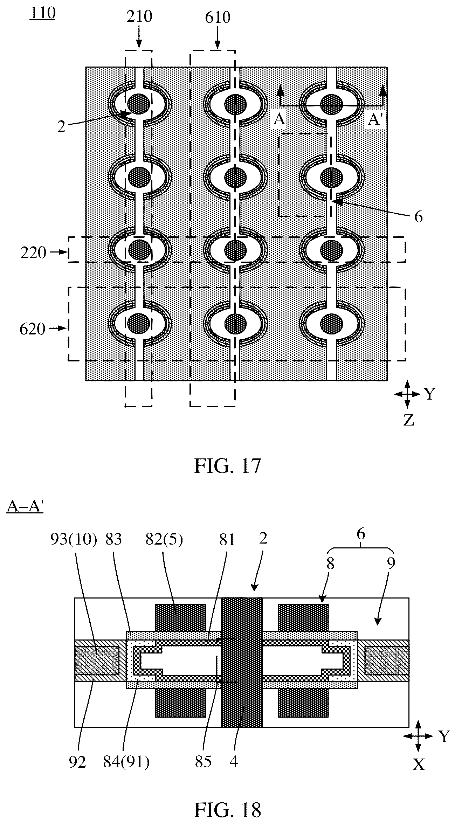

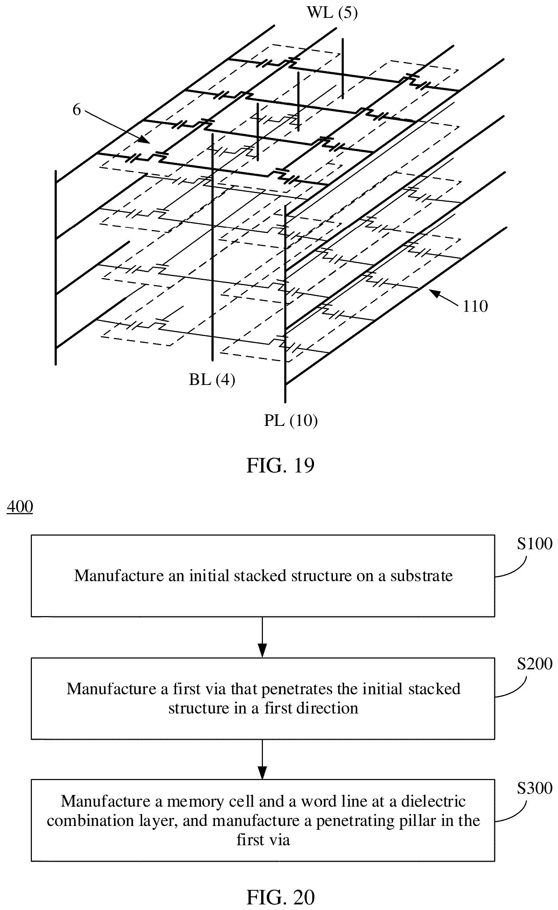

An embodiment of this application also provides another three-dimensional memory array. FIG. 16 is a diagram of a structure of a stacked structure 1 and a penetrating pillar 2 in the three-dimensional memory array. FIG. 17 is a top view of a memory layer 110 in FIG. 16. FIG. 18 is a cross-sectional view of A-A' in FIG. 17. FIG. 19 is a circuit diagram of a structure in FIG. 16. As shown in FIG. 16 to FIG. 19, a difference between the three-dimensional memory array in this embodiment and the three-dimensional memory array in the foregoing embodiment lies in the penetrating pillar 2. In this embodiment, only one bit line 4 is disposed on the penetrating pillar 2, and two memory cells 6 corresponding to the penetrating pillar 2 are connected to the same bit line 4.

For other descriptions of the three-dimensional memory, refer to the foregoing descriptions.

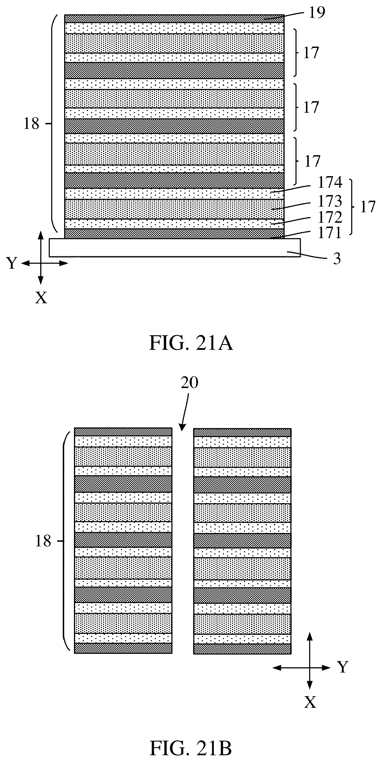

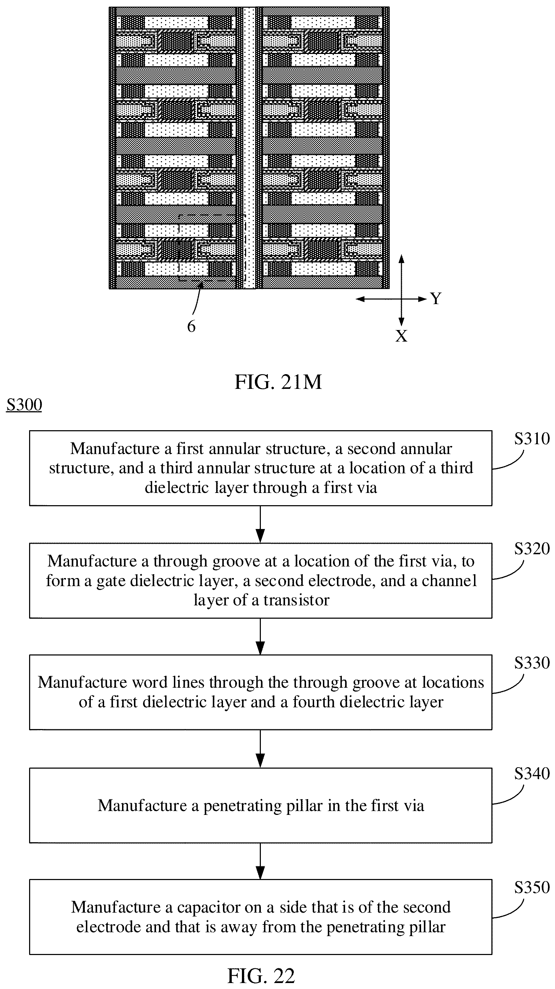

An embodiment of this application also provides a three-dimensional memory array preparation method. The preparation method is used to prepare the three-dimensional memory array 100 in the foregoing embodiments. FIG. 20 is a flowchart of a three-dimensional memory array preparation method according to an embodiment of this application. FIG. 21A to FIG. 21M are diagrams of structures of the three-dimensional memory array in FIG. 3 at different manufacturing stages. As shown in FIG. 22 and FIG. 21A to FIG. 21M, the three-dimensional memory array preparation method 400 includes the following steps.

Step S100: Manufacture an initial stacked structure on a substrate.

For descriptions of the substrate 3, refer to the foregoing descriptions. Details are not described herein again.

As shown in FIG. 21A, the initial stacked structure 18 includes a plurality of dielectric combination layers 17 disposed in a first direction X, and a top dielectric layer 19 located away from a top of the substrate 3, where the top dielectric layer 19 is used to protect the lower dielectric combination layers 17 to some extent. Each dielectric combination layer 17 is used to form one memory layer 110 in a subsequent step. Therefore, a quantity of dielectric combination layers 17 in the initial stacked structure 18 may be determined based on a designed quantity of memory layers 110 in a to-be-prepared three-dimensional memory array 100.

In a direction that is parallel to the first direction X and that is away from the substrate 3, the dielectric combination layer 17 includes a first dielectric layer 171, a second dielectric layer 172, a third dielectric layer 173, and a fourth dielectric layer 174 that are disposed in a stacked manner. The first dielectric layer 171, the second dielectric layer 172, the third dielectric layer 173, and the fourth dielectric layer 174 are prepared by using a dielectric material, the dielectric material may be one or a combination of silicon oxide, silicon nitride, and a high dielectric constant insulation material. In addition, the first dielectric layer 171, the second dielectric layer 172, the third dielectric layer 173, and the fourth dielectric layer 174 need to select an appropriate material based on an etching requirement in a subsequent step, to implement expected selective etching.

In the dielectric combination layer 17, the first dielectric layer 171, the second dielectric layer 172, the third dielectric layer 173, and the fourth dielectric layer 174 may be successively formed on one side of the substrate 3 by using a thin film deposition process like chemical vapor deposition (Chemical Vapor Deposition, CVD for short), physical vapor deposition (Physical Vapor Deposition, PVD for short), atomic layer deposition (Atomic Layer Deposition, ALD for short), or any combination thereof.

The initial stacked structure 18 is formed after a plurality of dielectric combination layers 17 are repeatedly manufactured.

It should be noted that, for ease of illustration, the substrate 3 is not shown in FIG. 21B to FIG. 21M.

Step S200: Manufacture a first via that penetrates the initial stacked structure in the first direction.

With reference to FIG. 21B, in step S200, the first via 20 that penetrates the initial stacked structure 18 in the first direction X is manufactured by using a material removal process like dry etching or wet etching. The first via 20 may be used for manufacturing a memory cell 6 in a subsequent process step.

Step S300: Manufacture a memory cell and a word line at the dielectric combination layer, and manufacture a penetrating pillar in the first via.

The penetrating pillar 2 includes a bit line 4 extending in the first direction X. At each dielectric combination layer 17, a memory cell 6 is connected to a word line 5 at a same dielectric combination layer 17, two memory cells 6 correspond to one penetrating pillar 2, and the two memory cells 6 corresponding to the penetrating pillar 2 are disposed opposite to each other on two sides of the penetrating pillar 2 in a second direction Y and are electrically connected to the bit line 4 in the penetrating pillar 2.

It can be learned from the foregoing descriptions that each dielectric combination layer 17 is used to form one memory layer 110 in a subsequent step. Therefore, the three-dimensional memory array formed in step S100 to step S300 includes a substrate 3, a stacked structure 1, and a plurality of penetrating pillars 2. The stacked structure 1 is disposed on the substrate 3, and the stacked structure 1 includes a plurality of memory layers 110 that are stacked in the first direction X perpendicular to the substrate 3; the memory layer 110 includes a plurality of word lines 5 and a plurality of memory cells 6; and the memory cells 6 are electrically connected to the word lines 5 at a same memory layer 110.

The penetrating pillar 2 penetrates the stacked structure 1 in the first direction X, and the penetrating pillar 2 includes a bit line 4 extending in the first direction X.

At each memory layer 110, two memory cells 6 correspond to one penetrating pillar 2, and the two memory cells 6 corresponding to the penetrating pillar 2 are disposed opposite to each other on two sides of the penetrating pillar 2 in the second direction Y and are electrically connected to a bit line 4 in the penetrating pillar 2.

In the three-dimensional memory array prepared by using the preparation method provided in this embodiment of this application, two memory cells 6 corresponding to one penetrating pillar 2 are disposed at each memory layer 110. In comparison with a solution in which one memory cell corresponding to one penetrating pillar is disposed at each memory layer in a related technology, in the three-dimensional memory array 100 in this embodiment of this application, more memory cells 6 can be disposed at the memory layer 110 in a same layout of the penetrating pillar 2, so that storage density and a storage capacity of the three-dimensional memory array 100 are improved.

In addition, the two memory cells 6 corresponding to the penetrating pillar 2 are disposed opposite to each other on the two sides of the penetrating pillar 2 in the second direction, so that space of the outer circumferential region of the penetrating pillar 2 can be appropriately used. Each memory cell 6 can be disposed at a location that is close to the corresponding penetrating pillar 2, so that a total area occupied by the two memory cells 6 corresponding to the penetrating pillar 2 at the memory layer can be reduced, more penetrating pillars 2 and memory cells 6 can be disposed in a same area, and storage density and a storage capacity of the three-dimensional memory array 100 are improved.

Because the three-dimensional memory array 100 has a plurality of different implementations, and structures of the penetrating pillar 2 and the memory cell 6 are also different, step S300 also has a plurality of different implementations corresponding to the different three-dimensional memory arrays 100. The following further describes step S300 by using an example in which the three-dimensional memory array 100 shown in FIG. 3 is prepared. It should be noted that the preparation method provided in this embodiment of this application is not limited to preparing the three-dimensional memory array 100 shown in FIG. 3. A person skilled in the art may perform adaptive adjustment based on the descriptions of preparing the three-dimensional memory array 100 in FIG. 3, to prepare a three-dimensional memory array 100 in another implementation in this embodiment of this application.

In some embodiments, as shown in FIG. 22, step S300 may include the following steps.

Step S310: Manufacture a first annular structure, a second annular structure, and a third annular structure at a location of the third dielectric layer through the first via.

In step S310, a part of a structure of the third dielectric layer 173 in the dielectric combination layer 17 may be removed by using the first via 20, then a material film layer is manufactured in space from which the structure is removed by using a thin film deposition process, and a target structure, for example, the first annular structure, the second annular structure, and the third annular structure, is formed after a redundant part of the material film layer is removed. The first annular structure, the second annular structure, and the third annular structure are all annular structures extending around the first via 20. The first annular structure is used to manufacture a gate dielectric layer 83 in a transistor 8, the second annular structure is used to manufacture a second electrode 84 in the transistor 8, and the third annular structure is used to manufacture a channel layer 81 of the transistor 8.

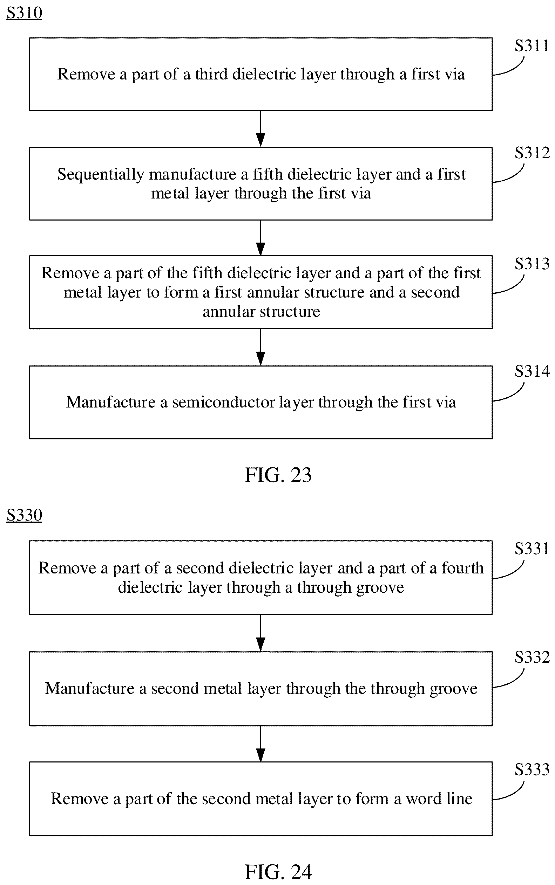

In some embodiments, as shown in FIG. 23, step S310 includes the following steps.

Step S311: Remove a part of the third dielectric layer through the first via.

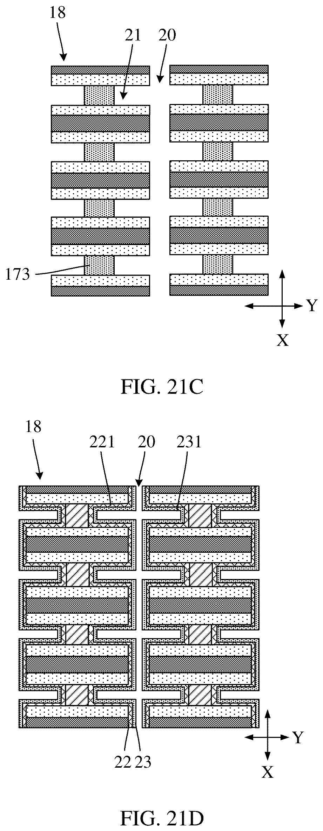

With reference to FIG. 21C, in step S311, a part of the third dielectric layer 173 is removed through the first via 20 by using a material removal process like dry etching or wet etching. After the part of the third dielectric layer 173 is removed, a first cavity 21 that is an annular and that extends around the first via 20 can be formed at a location of the third dielectric layer 173.

Step S312: Sequentially manufacture a fifth dielectric layer and a first metal layer through the first via.

With reference to FIG. 21D, the fifth dielectric layer 22 is used to manufacture a first annular structure 221, and the first annular structure 221 is used to manufacture the gate dielectric layer 83 in the transistor 8. The first metal layer 23 is used to manufacture a second annular structure 231, and the second annular structure 231 is used to manufacture the second electrode 84 in the transistor 8. Therefore, for material selection of the fifth dielectric layer 22 and the first metal layer 23, refer to the foregoing material descriptions of the gate dielectric layer 83 and the second electrode 84.

The fifth dielectric layer 22 and the first metal layer 23 may be sequentially formed by using a thin film deposition process like CVD, PVD, ALD, or any combination thereof. The formed fifth dielectric layer 22 covers a hole wall of the first via 20 and an inner wall of the first cavity 21, and the first metal layer 23 covers a surface of the fifth dielectric layer 22.

Step S313: Remove a part of the fifth dielectric layer and a part of the first metal layer to form the first annular structure and a second annular structure.

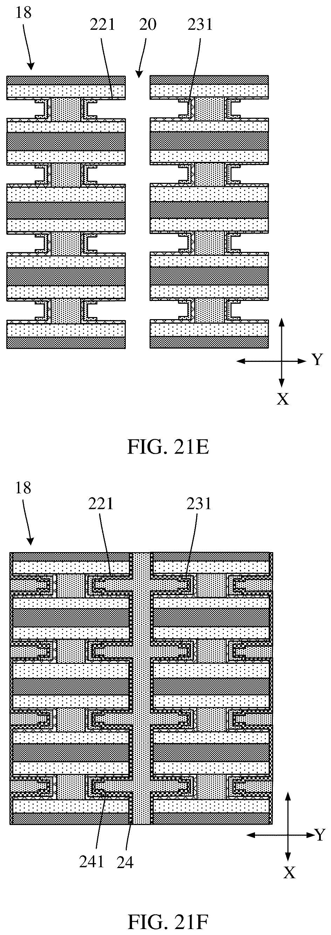

With reference to FIG. 21E, in step S313, a material removal process like dry etching or wet etching may be implemented through the first via 20 to remove a part of the fifth dielectric layer 22 and a part of the first metal layer 23. After the removal of the part of the fifth dielectric layer 22, the first annular structure 221 and the second annular structure 231 may be formed in the first cavity 21.

Step S314: Manufacture a semiconductor layer through the first via.

With reference to FIG. 21F, the semiconductor layer 24 is used to manufacture the channel layer 81 of the transistor 8. For material selection of the semiconductor layer, refer to the foregoing descriptions about the channel layer 81.

In step S340, the semiconductor layer 24 may be formed by using a thin film deposition process like CVD, PVD, ALD, or any combination thereof. The formed semiconductor layer 24 includes a part located in the first cavity 21 and a part located in the first via 20. The part located in the first cavity 21 covers inner wall surfaces of the first annular structure 221 and the second annular structure 231, and the part is a third annular structure 241. The part that is of the semiconductor layer 24 and that is located in the first via 20 covers the inner wall surface of the first via 20.

With reference to FIG. 21F, after the semiconductor layer 24 is manufactured, a gap surrounded by the semiconductor layer 24, for example, a gap at which the semiconductor layer 24 in located in the first cavity 21 and a gap in the first via 20, may be further filled through the first via 20 by using a dielectric material.

Step S320: Manufacture a through groove at a location of the first via, to form a gate dielectric layer, a second electrode, and a channel layer of the transistor.

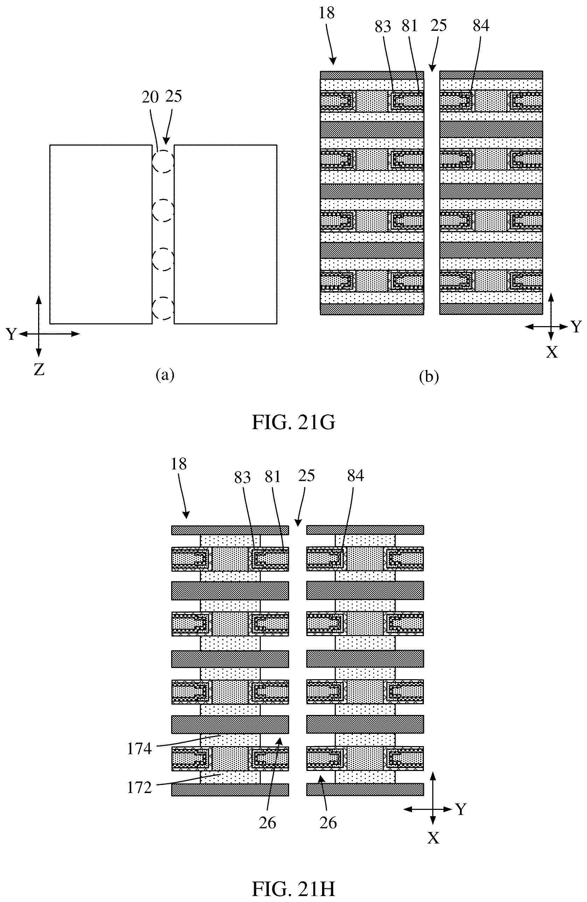

With reference to FIG. 21G, (a) in FIG. 21G is a top view of the initial stacked structure 18 in this step, and shows a location relationship between the through groove 25 and the first via 20. As shown in (a) in FIG. 21G, the through groove 25 extends at the location of the first via 20 in a third direction Z, and may be connected to a plurality of first vias 20 aligned in the third direction Z.

With reference to (b) in FIG. 21G, it can be seen that the through groove 25 simultaneously penetrates the initial stacked structure 18 in the first direction X.

The through groove 25 may be manufactured by using a material removal process like dry etching or wet etching. In a process of manufacturing the through groove 25, the part that is of the semiconductor layer 24 and that is located in the first via 20 and a filling material in the gap of the part are removed, and the third annular structure 241 located in the first cavity 21 and the dielectric material filled in the gap of the structure are retained. The third annular structure 241 is also divided into two semi-annular structures arranged in the second direction Y by the through groove 25, to form two semi-annular channel layers 81.

The first annular structure 221 is divided by the through groove 25 into two semi-annular structures arranged in the second direction Y, to form two semi-annular gate dielectric layers 83. The second annular structure 231 is divided by the through groove 25 into two semi-annular structures arranged in the second direction Y, to form two semi-annular second electrodes 84.

Step S330: Manufacture word lines through the through groove at locations of the first dielectric layer and the fourth dielectric layer.

In the three-dimensional memory array prepared in this embodiment, the word line 5 and the gate 82 of the transistor 8 are of an integrated structure. Therefore, in the process of manufacturing the word line 5 in step S330, the gate 82 of the transistor 8 is formed simultaneously.

Similar to the method for manufacturing the first annular structure, the second annular structure, and the third annular structure in step S310, in step S330, a part structure of the second dielectric layer 172 and the fourth dielectric layer 174 in the dielectric combination layer 17 may be removed through the through groove 25, and then a material film layer is manufactured in space in which the structure is removed by using a thin film deposition process, and a target structure, for example, the word line 5, is formed after a redundant part of the material film layer is removed.

In some embodiments, as shown in FIG. 24, step S330 may include the following steps.

Step S331: Remove a part of the second dielectric layer and a part of the fourth dielectric layer through the through groove.

With reference to FIG. 21H, materials in the second dielectric layer 172 and the fourth dielectric layer 174 may be removed by using a material removal process like dry etching and wet etching. After a part of the material of the second dielectric layer 172 is removed, two second cavities 26 extending in the third direction Z are formed on two sides of the through groove 25 in the second direction Y. After a part of the material of the fourth dielectric layer 174 is removed, two second cavities 26 extending in the third direction Z are formed on two sides of the through groove 25 in the second direction Y.

Step S332: Manufacture a second metal layer through the through groove.

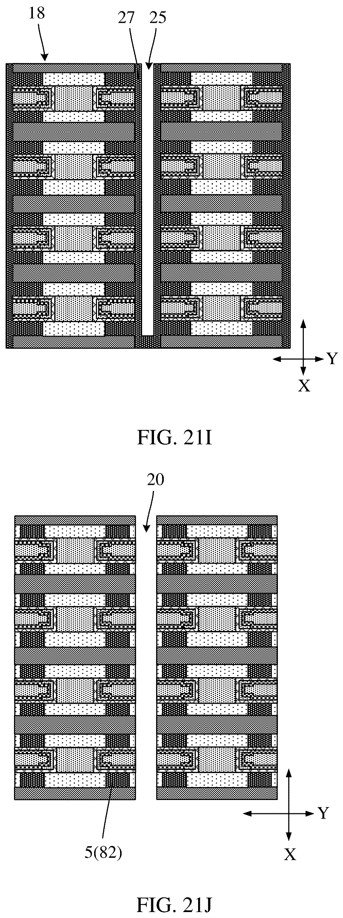

With reference to FIG. 21I, the second metal layer 27 is used to form the word line 5. Therefore, for material selection of the second metal layer 27, refer to the foregoing descriptions of the material of the word line 5.

The second metal layer 27 may be formed by using a thin film deposition process like CVD, PVD, ALD, or any combination thereof. The formed second metal layer 27 is partially filled in the second cavities 26 on the two sides of the through groove 25, and partially covers a groove wall of the through groove 25.

Step S333: Remove a part of the second metal layer to form a word line.

As shown in FIG. 21J, in step S333, a material removal process like dry etching or wet etching may be used to remove the part that is of the second metal layer 27 and that is located in the through groove 25, and retain the part that is located in the second cavity 26, to form the word line 5.

In this embodiment, the word line 5 and the gate 82 are of an integrated structure, and a part that is of the word line 5 and that is in contact with the gate dielectric layer 83 is simultaneously used as the gate 82 of the transistor 8.

With reference to FIG. 21J, after the word line 5 is manufactured, a part of a material that is of the word line 5 and that is close to the through groove 25 further needs to be removed through the through groove 25, and then a dielectric material is backfilled, to subsequently implement insulation isolation from a structure in the first via 20. The through groove 25 is filled after the dielectric material is backfilled. Therefore, the dielectric material needs to be removed from a location of the first via 20, to form the first via 20, so as to facilitate subsequent structure manufacturing.

It can be learned from the foregoing descriptions that the transistor 8 manufactured by using the preparation method is of a dual-gate structure. For a transistor 8 of a single-gate structure, only one of the second dielectric layer 172 and the fourth dielectric layer 174 may be disposed, and then a same process is used for implementation. Details are not described herein again.

Step S340: Manufacture a penetrating pillar in the first via.

It can be learned from the foregoing descriptions that the penetrating pillar 2 includes one or two bit lines 4 extending in the first direction X. In this embodiment, an example in which one penetrating pillar 2 includes two bit lines 4 is used. The two bit lines 4 in the penetrating pillar 2 are spaced from each other in the second direction Y, and insulation isolation is implemented between the two bit lines 4 by using a dielectric material.

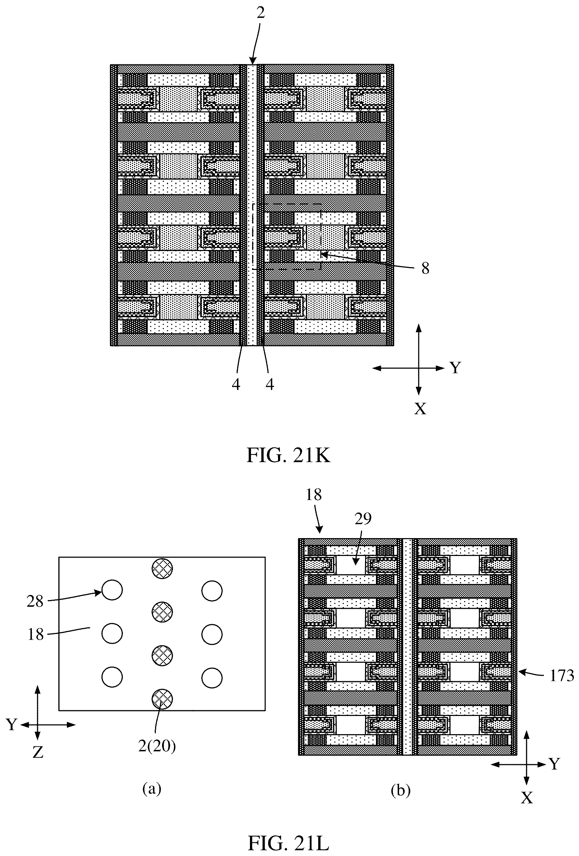

With reference to FIG. 21K, in some embodiments, step S340 includes: first manufacturing a third metal layer on a hole wall of the first via 20 by using a thin film deposition process, and then removing a part of the third metal layer by using a material removal process like dry etching or wet etching, to form the two bit lines 4 spaced from each other in the second direction Y.

Each formed bit line 4 extends in the first direction X, and is in contact with a channel layer 81 on a side close to the bit line 4. A part that is of the bit line 4 and that is in contact with the channel layer 81 is also constructed as the first electrode 85 of the transistor 8.

It can be learned from the foregoing descriptions that the third metal layer is used to manufacture the bit line 4 and the first electrode 85. Therefore, a material of the third metal layer may be selected based on the foregoing descriptions about the materials of the bit line 4 and the first electrode 85.

After the two bit lines 4 are manufactured, the first via 20 is filled with a dielectric material, to implement insulation isolation between the two bit lines 4.

For a penetrating pillar 2 including only one bit line 4, refer to the foregoing method. Details are not described herein again.

By using step S340, the penetrating pillar 2 is formed, and the transistors 8 in the memory cells 6 located on the two sides of the penetrating pillar 2 are also formed.

Step S350: Manufacture a capacitor on a side that is of the second electrode and that is away from the penetrating pillar.

The capacitor 9 is manufactured by using step S350, to form a memory cell 6 including the transistor 8 and the capacitor 9.

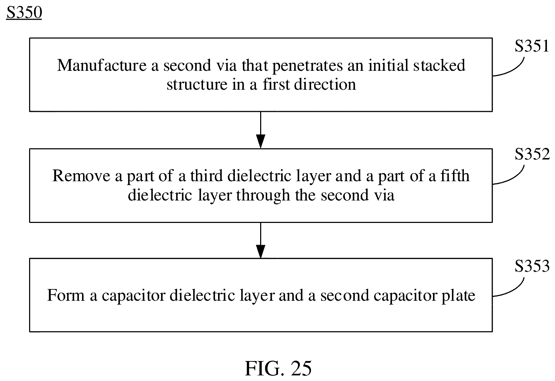

In some embodiments, as shown in FIG. 25, step S350 may include the following steps.

Step S351: Manufacture a second via that penetrates the initial stacked structure in the first direction.

In step S351, the second via 28 that penetrates the initial stacked structure 18 in the first direction X is manufactured by using a material removal process like dry etching or wet etching. The second via 28 may be used for manufacturing a memory cell 6 in a subsequent process step.

With reference to FIG. 21L, (a) in FIG. 21L is a top view of the initial stacked structure 18 in step S351. It can be learned from (a) in FIG. 21L that the first via 20 and the second via 28 are disposed at different locations, and are staggered in a row direction (the third aspect X) and a column direction (the second direction Y) of the memory cell at the memory layer.

Step S352: Remove a part of the third dielectric layer and a part of the fifth dielectric layer through the second via.

With reference to FIG. 21L, a material removal process like dry etching or wet etching may be used to remove a part of the material of the third dielectric layer 173 and a part of the material of the fifth dielectric layer 22. As shown in (b) of FIG. 21L, after the part of the material of the third dielectric layer 173 and the part of the material of the fifth dielectric layer 22 are removed, a third cavity 29 can be formed, and the second electrode 84 is exposed in the third cavity 29. The third cavity 29 simultaneously extends in the third direction Z, and is connected to a plurality of second vias 28 aligned in the third direction Z.

Step S353: Form a capacitor dielectric layer and a second capacitor plate.

With reference to FIG. 21M, after the third cavity 29 is formed, a sixth dielectric layer and a third metal layer may be successively manufactured in the third cavity 29 by using a thin film deposition process. The sixth dielectric layer is used to form a capacitor dielectric layer 92 in the capacitor 9, and the third metal layer is used to manufacture a second capacitor plate 93, a plate line 10, and a plate line column. Therefore, for material selection of the sixth dielectric layer and the third metal layer, refer to the foregoing related descriptions.

In the three-dimensional memory array prepared in this embodiment, the second electrode 84 of the transistor 8 of the memory cell 6 and the first capacitor plate 91 of the capacitor 9 are of an integrated structure. Therefore, the first capacitor plate 91 does not need to be manufactured in the step of manufacturing the capacitor 9.

After the sixth dielectric layer is manufactured, a part of the sixth dielectric layer covers a side surface that is of the second electrode 84 (the first capacitor plate 91) and that is away from the channel layer 81, and the part is the capacitor dielectric layer 92. A part that is of the third metal layer and that is in contact with the capacitor dielectric layer 92 is the second capacitor plate 93.

The third metal layer extends in the third cavity 29, and can further form the plate line 10 and the plate line column.

In the three-dimensional memory array prepared in step S100 to step S300, two memory cells 6 corresponding to one penetrating pillar are disposed at each memory layer 110, so that storage density of the three-dimensional memory array is improved. In addition, the memory cell 6 adopts a semi-annular structure relative to the penetrating pillar 2, so that processing and manufacturing of the memory cell 6 are facilitated, and manufacturing difficulty is reduced.

In addition, it can be learned from the descriptions in step S310 to step S350 that, in the three-dimensional memory array prepared by using the foregoing preparation method, a minimum size of a single memory cell 6 in the third direction Z may be 3F (a minimum line width that can be implemented by a process device), and a minimum size of a single memory cell 6 in the second direction Y may be 2F, so that a minimum projection area of the single memory cell 6 in a projection of a reference plane perpendicular to the first direction X is 6F². Therefore, it can be learned that a size of the memory cell 6 is small, and a projection area is small, so that storage density of the three-dimensional memory array is improved.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A three-dimensional memory array, comprising:
a substrate;
a stacked structure disposed on the substrate, wherein the stacked structure comprises a plurality of memory layers that are stacked in a first direction perpendicular to the substrate; and the memory layer comprises a plurality of word lines and a plurality of memory cells, and the memory cells are electrically connected to the word lines at a same memory layer; and
a plurality of penetrating pillars that penetrate the stacked structure in the first direction, wherein the penetrating pillar comprises a bit line extending in the first direction, wherein
at each memory layer, two memory cells correspond to one penetrating pillar, and the two memory cells corresponding to the penetrating pillar are disposed opposite to each other on two sides of the penetrating pillar in a second direction and are electrically connected to a bit line in the penetrating pillar; and
the first direction is perpendicular to the second direction.

2. The three-dimensional memory array according to claim 1, wherein the two memory cells corresponding to the penetrating pillar at the memory layer are of a symmetrical structure relative to the penetrating pillar.

3. The three-dimensional memory array according to claim 1 or 2, wherein the memory cell comprises a transistor and a capacitor electrically connected to the transistor; and
the transistor comprises:
a channel layer, wherein the channel layer is disposed on one side of the penetrating pillar;
a gate dielectric layer, disposed on at least one side of the channel layer in the first direction;
a gate connected to the word line at the memory layer, wherein the gate is disposed on a side that is of the gate dielectric layer and that is away from the channel layer in the first direction; and
a first electrode and a second electrode that are disposed on two sides of the channel layer in the second direction, wherein
the second direction is perpendicular to the first direction, and the first electrode and the bit line in the penetrating pillar are of an integrated structure or of independent structures that are electrically connected to each other; and the second electrode is far away from the penetrating pillar relative to the channel layer and is connected to the capacitor.

4. The three-dimensional memory array according to claim 3, wherein the first electrode and the bit line are of an integrated structure, and the channel layer, the gate dielectric layer, and the second electrode are of semi-annular structures extending around the penetrating pillar in an outer circumferential region of the penetrating pillar; or
the first electrode and the bit line are of independent structures that are electrically connected to each other, and the first electrode, the channel layer, the gate dielectric layer, and the second electrode are semi-annular structures extending around the penetrating pillar in the outer circumferential region of the penetrating pillar.

5. The three-dimensional memory array according to claim 3 or 4, wherein the second electrode comprises a first part, a second part, and a third part, and the first part extends in the first direction and is in contact with an outer circumferential surface of the channel layer;
the second part and the third part are disposed opposite to each other at two ends of the first part in the first direction, and extend towards the channel layer in the second direction; and
the second part and the third part are respectively in contact with opposite surfaces of the channel layer in the first direction.

6. The three-dimensional memory array according to any one of claims 1 to 5, wherein the three-dimensional memory array further comprises a plate line;
the memory cell comprises the transistor and the capacitor arranged in the second direction, the second direction is perpendicular to the first direction, and the capacitor is away from the penetrating pillar relative to the transistor;
the transistor comprises the gate, the first electrode, and the second electrode, the gate is connected to the word line, the first electrode is connected to the bit line, and the second electrode is connected to the capacitor; and
the capacitor comprises a first capacitor plate, a capacitor dielectric layer, and a second capacitor plate that are arranged in the second direction, and the first capacitor plate and the second electrode in the transistor are of an integrated structure or of independent structures that are electrically connected to each other; and the second capacitor plate and the plate line are of an integrated structure or of independent structures that are electrically connected to each other.

7. The three-dimensional memory array according to claim 6, wherein a material of the capacitor dielectric layer comprises any one of a ferroelectric material, an insulation material, a phase change material, a resistive material, or a ferromagnetic material.

8. The three-dimensional memory array according to claim 6 or 7, wherein the second capacitor plate and the plate line are of an integrated structure, and the first capacitor plate and the capacitor dielectric layer are semi-annular structures extending around the penetrating pillar in the outer circumferential region of the penetrating pillar; or
the second capacitor plate and the plate line are of independent structures that are electrically connected to each other, and the first capacitor plate, the capacitor dielectric layer, and the second capacitor plate are of semi-annular structures extending around the penetrating pillar in the outer circumferential region of the penetrating pillar.

9. The three-dimensional memory array according to any one of claims 6 to 8, wherein the first capacitor plate has a fitting groove with an opening facing the second capacitor plate; and the second capacitor plate comprises a fitting part extending into the fitting groove, and the capacitor dielectric layer is disposed in a gap between the fitting groove and the fitting part.

10. The three-dimensional memory array according to claim 9, wherein the first capacitor plate comprises a fourth part, a fifth part, and a sixth part, the fourth part extends in the first direction, and the fifth part and the sixth part are disposed at two ends of the fourth part in the first direction and both extend towards the second capacitor plate; and
the fourth part, the fifth part, and the sixth part form the fitting groove through limitation.

11. The three-dimensional memory array according to any one of claims 6 to 10, wherein the memory cells at the memory layer are arranged in rows and columns, and a column direction is parallel to the second direction; and
memory cells located in a same column comprise two adjacent memory cells whose capacitors are close to each other, and second capacitor plates that are of the two capacitors and that are in the two adjacent memory cells whose capacitors are close to each other are of an integrated structure.

12. The three-dimensional memory array according to any one of claims 1 to 11, wherein the penetrating pillar comprises two bit lines, and the two memory cells corresponding to the penetrating pillar are connected to the two bit lines in the penetrating pillar in a one-to-one correspondence; or
the penetrating pillar comprises one bit line, and the two memory cells corresponding to the penetrating pillar are connected to the bit line in the penetrating pillar.

13. The three-dimensional memory array according to any one of claims 1 to 12, wherein the three-dimensional memory array comprises a word line and a bit line, and a connection manner between the two memory cells corresponding to the penetrating pillar and the word line and the bit line comprises:
the two memory cells are connected to different word lines and different bit lines;
the two memory cells are connected to a same word line and different bit lines; and
the two memory cells are connected to different word lines and a same bit line.

14. The three-dimensional memory array according to any one of claims 1 to 13, wherein the three-dimensional memory array further comprises an interconnection structure and a plurality of interconnection contacts, and the interconnection contacts are connected to the word line in the stacked structure and the interconnection structure;
the stacked structure comprises an array region and an electrical connection region that are arranged in a third direction; the memory cell is located in the array region, and the word line extends to the electrical connection region and is connected to the interconnection contact in the electrical connection region; and the third direction is perpendicular to the first direction; and
a connection manner between the word line, the interconnection contact, and the interconnection structure comprises:
the interconnection structure is disposed in a top region or a bottom region of the stacked structure, and the memory layers in the stacked structure extend in the third direction and form a step structure in the electrical connection region; and the word line at the memory layer is exposed on a side that is of the step structure and that is close to the interconnection structure, and the interconnection contact extends in the first direction and is connected to the interconnection structure and the word line; and
the interconnection structure is disposed in a top region or a bottom region of the stacked structure, the word line at the memory layer extends in the electrical connection region and is exposed on a surface of a side that is of the electrical connection region and that is close to the interconnection structure, and the interconnection contact extends in the first direction and is connected to the interconnection structure and the word line.

15. A three-dimensional memory array preparation method, wherein the preparation method comprises:
manufacturing an initial stacked structure on a substrate, wherein the initial stacked structure comprises a plurality of dielectric combination layers stacked in a first direction perpendicular to the substrate;
manufacturing a first via that penetrates the initial stacked structure in the first direction; and
manufacturing a memory cell and a word line at a dielectric combination layer, and manufacturing a penetrating pillar in the first via, wherein
the penetrating pillar comprises a bit line extending in the first direction; and at each dielectric combination layer, the memory cell is connected to the word line at a same dielectric combination layer, two memory cells correspond to one penetrating pillar, and the two memory cells corresponding to the penetrating pillar are disposed opposite to each other on two sides of the penetrating pillar in a second direction and are electrically connected to the bit line in the penetrating pillar; and
the first direction is perpendicular to the second direction.

16. The preparation method according to claim 15, wherein the dielectric combination layer comprises a first dielectric layer, a second dielectric layer, a third dielectric layer, and a fourth dielectric layer that are disposed in a stacking manner in the first direction; and
the manufacturing the memory cell and the word line at the dielectric combination layer, and manufacturing the penetrating pillar in the first via comprises:
manufacturing a first annular structure, a second annular structure, and a third annular structure at a location of the third dielectric layer through the first via, wherein the first annular structure, the second annular structure, and the third annular structure extend around the first via;
manufacturing a through groove at a location of the first via, to form a gate dielectric layer, a second electrode, and a channel layer of a transistor, wherein the through groove extends in a third direction, and penetrates through the initial stacked structure in the first direction; the first annular structure is divided by the through groove, to form two semi-annular gate dielectric layers that are located on two sides of the first via in the second direction; the second annular structure is divided by the through groove, to form two semi-annular second electrodes that are located on the two sides of the first via in the second direction; and the third annular structure is divided by the through groove, to form two semi-annular channel layers that are located on the two sides of the first via in the second direction;
manufacturing, through the through groove at locations of the first dielectric layer and the fourth dielectric layer, word lines extending in the third direction, wherein a part that is of the word line and that is in contact with the gate dielectric layer is a gate of the transistor;
manufacturing the penetrating pillar in the first via, wherein the penetrating pillar comprises a bit line extending in the first direction, the bit line is in contact with the channel layer on one side, and a part that is of the bit line and that is in contact with the channel layer is a first electrode of the transistor; and
manufacturing a capacitor on a side that is of the second electrode and that is away from the penetrating pillar, wherein
the first direction, the second direction, and the third direction are perpendicular to each other.

17. The preparation method according to claim 16, wherein the manufacturing the capacitor on the side that is of the second electrode and that is away from the penetrating pillar comprises:
manufacturing a second via that penetrates the initial stacked structure in the first direction; and
manufacturing a capacitor dielectric layer and a plate line at the location of the third dielectric layer through the second via, wherein a part that is of the plate line and that is in contact with the capacitor dielectric layer is a second capacitor plate of the capacitor.

18. A memory, comprising:
a controller and the three-dimensional memory array according to any one of claims 1 to 14, wherein the controller is electrically connected to the three-dimensional memory array.

19. An electronic device, comprising:
a circuit board and the memory according to claim 18, wherein the circuit board is electrically connected to the memory.
